# EUROPEAN PATENT APPLICATION

(11) **EP 1 542 524 A1**
(43) Date of publication of application: **15.06.2005**
(21) Application number: 03788040.8
(22) Date of filing: 06.08.2003
(51) Int. Cl.: H05K 13/04

(54) **METHOD AND EQUIPMENT FOR MOUNTING PART**

(30) Priority: 06.08.2002 JP 2002229037; 08.11.2002 JP 2002324979
(71) Applicant: MATSUSHITA ELECTRIC INDUSTRIAL CO., LTD., Kadoma-shi, Osaka 571-8501 (JP)
(72) Inventor: MAEDA, Takashi, Kofu-shi, Yamanashi 400-0058 (JP); OKUDA, Osamu, Nakakoma-gun, Yamanashi 409-3803 (JP); UCHIYAMA, Hiroshi, Kofu-shi, Yamanashi 400-0056 (JP); YAZAWA, Takashi, Kitakoma-gun, Yamanashi 407-0108 (JP); IMAGAWA, Hiroaki, Nakakoma-gun, Yamanashi 409-3843 (JP); NAGASAWA, Yosuke, Minamiarupusu-shi, Yamanashi 400-0301 (JP); HIRAI, Wataru, Nakakoma-gun, Yamanashi 409-3866 (JP); NAKASHIMA, Makoto, Kofu-shi, Yamanashi 400-0828 (JP); KOUKETSU, Naoto, Kofu-shi, Yamanashi 400-0042 (JP)
(74) Representative: Eisenführ, Speiser & Partner
(86) International application number: PCT/JP2003/009970
(87) International publication number: WO 2004/017704

(57) **Abstract**

The present invention is to provide a method and an apparatus for mounting components having a feature of detecting with high accuracy component pick up failure by the nozzle at component pick up stage, and/or component carrying back by the nozzle at component mounting stage. Achieved vacuum pressure is initialized to zero after completion of component pick up by the nozzle 25, and vacuum pressure decrease of the nozzle 25 is detected from the initialized zero point. If the detected value is bigger than the predetermined threshold, it may be judged that at least one of the nozzles failed to pick up a component. The failed nozzle may be identified by using a component recognition device 37. Blowing air blow volume flowing through the nozzle 25 is measured upon completion of component mounting. If the blowing air flow is smaller that the predetermined threshold, it is judged that the nozzle 25 carries back a component 30. Two thresholds may be used, and it may be judged that the component has been properly mounted if the measurement value is bigger than both thresholds, filter 22 is clogged if the measurement value is in between the two thresholds, and the nozzle 25 carries back the component if the measurement value is smaller than both thresholds.

## Description

### Technical Field

Present invention relates to a method and apparatus for mounting components by picking up components, such as electronic components from component supply, and mounting the same onto respective predetermined positions of a circuit substrate. More specifically, the present invention relates to a method and apparatus for mounting components, including procedures for detecting whether or not a nozzle for picking up a component fails to pick up a component at component pick up stage, and/or detecting whether or not a nozzle fails to mount a component at component mounting stage and carries back the component.

### Background Art

Component mounting apparatus having nozzles for picking up components by means of sucking effect generated by vacuum pressure generally comprises: a component supply for supplying components continuously to a component mounting apparatus; a mounting head holding one or more nozzles for picking up components from the component supply and mounting the same onto a circuit substrate; a transporting device for transporting the mounting head to and from the mounting position; a component recognition device for recognizing and determining condition of the component held by the nozzle; and a substrate holder for transporting a circuit substrate into the component mounting apparatus and placing the circuit substrate at its position.

The component mounting apparatus as structured above operates as follows. First, a plurality of nozzles held by the mounting head pick up components supplied at the component supply continuously. Then, the mounting head is moved by the transporting device over the component recognition device, during which time a recognition camera of the recognition device images condition of the component held by the nozzle. The mounting head is moved further toward the position where the circuit substrate is firmly held at its position by the substrate holder. The mounting head stops at the position facing a predetermined mounting position of the circuit substrate so that the nozzles may descend against the circuit substrate and mount the components onto the circuit substrate. All of the above operations performed by the component mounting apparatus are controlled by a controller mounted inside the component mounting apparatus.

Sucking components with a plurality of nozzles at pick up stage, as well as separating the components from the associated nozzles at mounting stage are regulated by switching operation of the nozzle. The nozzle is connected to either vacuum supply source or pressurized air supply source by a switching device using electromagnetic valve or the like. More specifically, when picking up a component, the switching device regulates the nozzle to be connected to vacuum supply so that the nozzle may pick up the component by means of sucking effect of vacuum pressure. When mounting a component, the switching device change the connection of the nozzle from vacuum supply source to pressurized air supply source so that the nozzle may separate the component and mount the same onto the circuit substrate by means of air blowing effect.

In recent years, many types of electronic components have been developed, and needs for multi-functional component mounting apparatus capable of mounting a variety types of component are arising. Major issue for such a multi-functional component mounting apparatus is not only to perform high speed and flexible mounting, but also to have a capability of preventing occurrence of defective products, such as circuit substrates with missing components, and to have a capability of improving overall mounting quality.

In order to prevent occurrence of defective circuit substrates, the nozzle needs to pick up the component from the component supply without failure, and needs to mount the component properly onto the predetermined position of the circuit substrate. Toward this end, a nozzle without holding a component for some reasons, such as lack of component supply or failure of pick up operation, needs to be detected by using the component recognition device. When such a nozzle without holding a component is detected, component mounting operation by such a nozzle is to be skipped, and the nozzle is arranged to repeat the same operations from component pick up to component mounting so as to prevent occurrence of defective substrate with missing components.

The nozzle is also checked after completion of mounting operation by using the component recognition device or other sensors with the intension of finding out whether or not the nozzle carries back the picked up component for some reasons, such as failure of component separation at component mounting stage. When it is detected that the nozzle is carrying back the component, the nozzle or any other nozzles is to be arranged to repeat the same operation from component pick up to component mounting so as to prevent occurrence of defective substrates.

As components to be mounted on a circuit substrate are becoming smaller, and the number of components to be mounted on a single circuit substrate is increasing in these days, the size of nozzle tends to be smaller for matching the small sized component, and for avoiding interference with neighboring components having been mounted on the same circuit substrate. In this connection, an area of a nozzle opening through which sucking or blowing air passage is narrowed, thereby amount of vacuum air or pressurized air passing through the nozzle is limited. Accordingly, rate of occurrence of failure during sucking and mounting operations tends to increase recently. From such perspective, it becomes very important to detect and find out whether or not the nozzle fails to pick up a component and/or whether or not the nozzle carries back a component in order to prevent occurrence of defective substrates.

### Disclosure of Invention

### (Problems to be solved by the present invention)

Even if the component recognition device could detect that the nozzle has successfully picked up the component, there is a possibility that the nozzle might drop the component after such detection by the recognition device has completed. In such a case, there are no other detecting devices disposed after the position of the component recognition device, and the nozzle without having a component would perform mounting operation, whereby the circuit substrate would be a defective product due to missing component. In a similar manner, even if the component recognition device could detect that the nozzle no longer has a picked up component after component mounting operation, hence the nozzle is not carrying back the component, there is a possibility that the nozzle has failed to separate the component during mounting operation, but the nozzle later has dropped the component before reaching to position of the component recognition device. This case too causes occurrence of defective substrate, since component missing might not be detected at any timing.

To cope with such situations, it is known in prior art a variety of techniques for minimizing traveling distance and traveling time of the mounting head between mounting position and detecting position, and techniques for detecting the nozzle as early as possible after completion of component mounting operation. In this specification, detecting component loss during and after component pick up operation is hereinafter referred to as "component loss detection", while detecting component carried back by the nozzle is hereinafter referred to as "mounting failure detection", and these two phenomena are distinguished from each other.

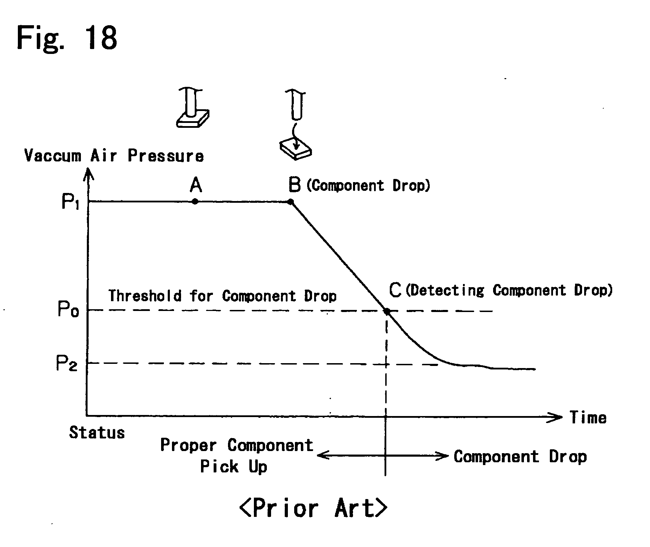

First, with regard to component loss detection, it is known in prior art to monitor vacuum pressure in the nozzle by means of a vacuum sensor, and to found out component loss when vacuum pressure decreases lower than a certain threshold (i.e., when vacuum pressure becomes closer to normal atmosphere than the threshold.). Fig. 18 shows principle of such detection. Referring to Fig. 18, vertical line represents vacuum pressure (stronger vacuum effect at higher level), and horizontal line represents time elapsing. Normally, at point A where a component is being held by a nozzle, higher vacuum pressure P1 is maintained since a nozzle opening is closed by the component. When the component drops from the nozzle, the vacuum pressure becomes lower because the nozzle opening is cleared hence atmospheric air may flow into the nozzle. Assuming that a component drops at point B, vacuum pressure becomes lower than the predetermined threshold P0 as time goes by, which makes it possible to judge that the component is lost when the vacuum pressure reaches to the threshold P0. Pressure level P2 is saturated pressure after the component is lost.

According to the above mentioned measure, however, it may be effective when the individual nozzle is connected to a respective vacuum generating source. If a system has a plurality of nozzles which perform component picking up operation by using a common vacuum generator, it becomes difficult to make accurate judgment by the above system since vacuum level to be achieved after completion of component pick up operation may vary in wide range depending upon a variety of sucking conditions. Such phenomenon of vacuum pressure variation comes from the fact that when one of the nozzles failed to pick up a component, air leakage occurs at that nozzle, which causes negative impact on vacuum pressure at all other nozzles. For example, in case a nozzle having a big opening drops a component, or in case a plurality of nozzles drop the associated components, influence of vacuum leakage is so big that sucking power at other nozzles may be deteriorated even when sufficient vacuum pressure is supplied. In such a case where variance of vacuum pressure due to air leakage is big, it may be not possible to make an accurate judgment that a component is lost only if vacuum pressure becomes lower than the predetermined threshold P0.

One possible solution for the above problem in prior art is to employ a plurality of vacuum supply sources which may be connected to a plurality of nozzles on one by one basis. In such a case, however, other problems become evident in that sucking pressure becomes low, and timing response when supplying vacuum pressure is deteriorated. As a plurality of vacuum supply sources are disposed, weight of the mounting head increases, which gives negative impact on capability of high speed mounting operation. In addition, having a plurality of vacuum supply source inevitably increases cost.

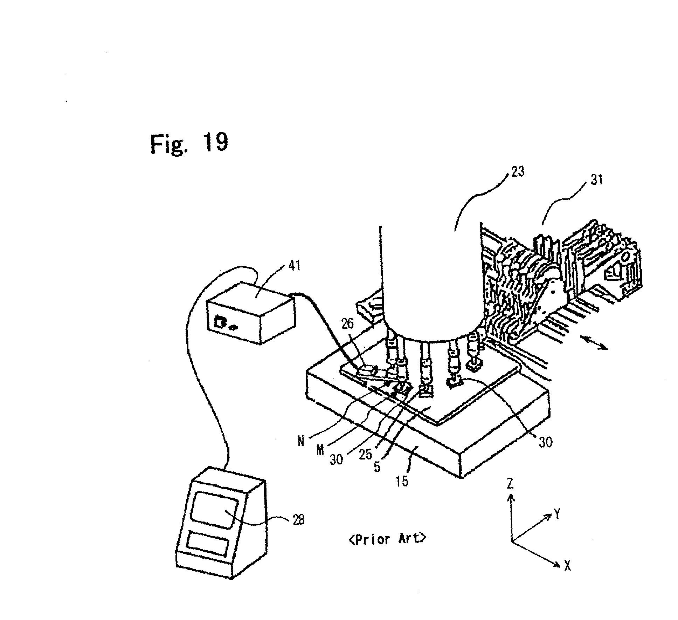

On the other hand, with regard to detecting mounting failure after component mounting operation, a method is known in prior art in which a flow meter as show in Fig. 19 is used. Referring to Fig. 19, a mounting head 23 (i.e., index, in the shown example in Fig. 19) holds a plurality of nozzles 25 on its circumference in a circular manner for rotating intermittently. During such intermittent rotation of the mounting head 23, each nozzle 25 sucks a component 30 and pick it up from component supply 31 at component pick up station located in a distant side in Y direction of the drawing, and mount the component 30 onto a circuit substrate 5 at component mounting station M located at forehand side in Y direction. A circuit substrate 5 is firmly held at its position by substrate holder 15.

According to the above method, a flow detecting station N is formed at a certain position after the component mounting station M, and air flow volume blowing out of the nozzle 25 is detected by using a flow meter 26. When a nozzle 25 arrives at the air flow detecting station N, the nozzle 25 descends toward a circular vessel surrounded by a ring type seal, and blows air into the vessel in a sealed condition. The air flow volume blown from the nozzle 25 is measured by flow meter 26 which is connected to the circular vessel. If the nozzle 25 has failed to mount a component and is still holding it (carrying back), the air flow volume is reduced due to blockage by the carrying component 30. The controller 41 compares the measured air flow volume with a preliminarily inputted threshold, and make a judgment whether the component 30 is still carried by the nozzle 25 or not. The result of the detection is shown on the screen 28.

According to a method described above, certain improvement may be achieved, as component carrying back may be detected after component mounting operation. Nevertheless, there still exists a drawback in the above method in that the nozzle 25, which has completed mounting operation, still needs to move for a certain length of distance in a certain length of time toward the flow volume detecting station N where the flow meter 26 is disposed. Therefore, there is a risk that the component 30 may drop from the nozzle and be lost during the time of such movement. It was not possible to measure air flow volume of the nozzle 25 at the component mounting station M with the intention of avoiding the above risk, because there is no enough space for disposing the flow meter 26. In the prior art, measurement result of such air flow using the flow meter is utilized only for detecting mounting failure.

Accordingly, the purpose of the present invention is to provide a method and apparatus for mounting components which may improve quality of component mounting operation by detecting phenomena during a component mounting operation, which phenomena include a failure of picking up a component to be mounted, dropping of a component from the nozzle which component has been once picked up by the nozzle, and/or a failure to separate a component for mounting and carrying back the component by the nozzle, all of which detection may be performed before or immediately after the component mounting operation so as to avoiding any misjudgment.

### (Means for solving the problems)

The present invention solves the above described problems by the following means. As for detecting component loss prior to component mounting operation, achieved vacuum pressure at the time of completion of component mounting is initialized to zero, and vacuum pressure decrease from the initialized zero point is detected and compared with a predetermined threshold. As for detecting mounting failure after completion of component mounting operation, blowing air flow volume or air pressure used for separating a component from the nozzle is measured and compared with a predetermined threshold. Through these procedures, component loss and/or component mounting failure may be reliably detected, thereby the problems described above may effectively be solved. More specifically, the present invention includes the following aspects.

One aspect of the present invention relates to a method of component mounting for picking up components and mounting the same onto respective predetermined mounting positions of a circuit substrate by means of a plurality of nozzles connected to a single vacuum generating source, in which the method includes procedures for preventing occurrence of defective circuit substrates due to missing component, the procedures comprise steps of: initializing achieved vacuum pressure of a nozzle after completion of component pick up operation to zero; detecting vacuum pressure decrease of the nozzle from the initialized zero value; and if the detected vacuum pressure decrease exceeds predetermined first threshold, making a judgment that the nozzle has failed to pick up a component, and skipping component mounting operation by that particular nozzle.

According to the above method, component loss due to component drop from the nozzle after having been picked up by the nozzle may reliably be detected without being affected by variance of the achieved vacuum pressure level after completion of component pick up operation, because the achieved vacuum pressure is initialized to zero. By initialing the achieved vacuum pressure after component pick up to zero, and pressure change (vacuum pressure decrease) is detected from the initialized zero point, component loss due to drop may be reliably detected by providing only one threshold, without being affected by achieved vacuum pressure variance.

Furthermore, when component loss is detected by pressure change detection, the particular nozzle without holding a component may be arranged to skip subsequent component mounting operation, thereby it becomes possible to prevent occurrence of defective circuit substrate due to missing component. When component loss is detected, the nozzle which has lost the component may be identified through recognition procedures, and the nozzles other than such identified nozzle may be allowed to perform component mounting operations. Accordingly, component held by these other nozzles may effectively be utilized for mounting operations, thereby waist of components may be avoided.

Another aspect of the present invention relates to a method comprising steps of: before initializing the achieved vacuum pressure of a nozzle to zero as described above, detecting absolute value of the vacuum pressure achieved by the nozzle after completion of component pick up operation, and if the detected achieved vacuum pressure is lower than predetermined second threshold, shutting a vacuum air passage of that particular nozzle.

According to the above aspect of the present invention, absolute value of the achieved vacuum pressure is detected, and it is judged that at least one of the nozzles failed to pick up a component, and vacuum is leaking from that nozzle, if the measured value is smaller that the predetermined second threshold. After identifying the nozzle that has failed to pick up a component, vacuum air passage of that failed nozzle is shut. By such procedures, vacuum air leakage may be prevented, and vacuum pressure connected to vacuum line is recovered, hence creating stable sucking condition of nozzles other than the failed nozzle may become possible. It is also possible to generate an alarm signal upon detecting that the achieved vacuum pressure is smaller than the second threshold, since there is a possibility that other nozzles may drop picked up components due to the lower sucking power.

The nozzle that has failed to pick up a component may be identified by image date by scanning each nozzle with recognition camera. Through such procedures, vacuum air leakage from the failed nozzle may be prevented by identifying the failed nozzle by using a simple system including a recognition camera, since the nozzle without having a component may be identified by image data obtained by scanning of the camera.

It is also possible to image the nozzles one more time for detecting whether or not any of the nozzles have lost a component after identifying the failed nozzle based on the image data and shut the vacuum air passage of the identified nozzle. According to this procedure, it becomes possible to more accurately detect nozzles without holding components, by imaging the nozzles by the recognition camera again after the vacuum air passage of the identified nozzle is shut.

All the nozzles, except the nozzles which are detected that components are not being held and the nozzles whose vacuum air passages are shut, may be allowed to perform component mounting operation. Therefore, components held by those nozzles need not be discarded, but rather be effectively utilized through component mounting operation.

Another aspect of the present invention relates to a component mounting apparatus comprising: a vacuum generating source; a plurality of nozzles connected to said vacuum generating source, each of which nozzles has a control valve capable of shutting a vacuum air passage; a mounting head being supported in a movable manner and holding said plurality of nozzles; a component recognition device positioned to face with the mounting head for recognizing components held by the nozzles; and a controller for controlling operations of the component mounting apparatus in accordance with a method according to any one of the above described method.

According to the above component mounting apparatus, the nozzle may be regulated either in open condition or in closed condition. When the nozzle is in open condition, the nozzle may suck and hold a component. By moving the mounting head over a component recognition device after component pick up operation, it becomes possible to identify which nozzle holds a component and which nozzle does not. The controller then controls component mounting operation according to either one of the method described above. The mounting operation may not be affected by variance of achieved vacuum pressure after completion of component pick up, and may prevent occurrence of defective circuit substrate since component loss from the nozzle may be reliably detected.

Yet another aspect of the present invention relates to a method of component mounting for picking up a component by means of vacuum sucking effect of a nozzle, and separating the component from the nozzle and mounting the same onto a predetermined mounting position of a circuit substrate by means of air blowing effect of the nozzle, in which the method includes procedures for preventing occurrence of defective substrates, which procedures comprise steps of; measuring air flow volume blown from the nozzle at an air flow passage at a timing immediately after completion of component mounting operation, which air flow passage is provided for supplying pressurized air to the nozzle; and making a judgment that the component has not been mounted onto the circuit substrate, if the measurement value is smaller than a predetermined threshold.

It is also possible that the above method is to be arranged to comprise two thresholds, and said procedures comprise steps of: making a judgment that the component has not been mounted onto the circuit substrate, if the measurement value is smaller than both of the thresholds; and making a judgment that the component has been mounted onto the circuit substrate, but that a filter disposed at the air flow passage is clogged, if the measurement value is in between the two thresholds. In this case, it is also possible that the procedures are to be arranged to comprise steps of: measuring blowing air flow volume at two different timings immediately after completion of component mounting operation; making a judgment whether or not the component has been properly mounted onto the circuit substrate based on the first measurement value; and making a judgment either the component has been mounted onto the circuit substrate but the filter is clogged, or the component has not been mounted onto the circuit substrate based on the second measurement value.

Yet another aspect of the present invention relates to a method of component mounting including procedures for preventing occurrence of defective substrates, which procedures comprise steps of; measuring differential of air flow volume blown from the nozzle at an air flow passage at a timing immediately after completion of component mounting operation, which air flow passage is provided for supplying pressurized air to the nozzle; and making a judgment that the component has not been mounted onto the circuit substrate, if the differential of air flow volume decrease obtained by the measurement is bigger than a predetermined threshold.

The above method may also be arranged to comprise two thresholds, and the procedures comprise steps of making a judgment whether a filter disposed at an air flow passage is clogged or not, in addition to making a judgment whether the component has been mounted or not. The procedures may also be arranged to perform the above measurement at two different timings, and utilize the measurement results for making the above described judgments.

Yet another aspect of the present invention relates to a method of component mounting including procedures for preventing occurrence of defective substrates, which procedures comprise steps of; measuring blowing air pressure blown from the nozzle at an air flow passage at a timing immediately after completion of component mounting operation, which air flow passage is provided for supplying pressurized air to the nozzle; and making a judgment that the component has not been mounted onto the circuit substrate, if the measurement value is bigger than a predetermined threshold. The above aspect is also possible to be arranged to comprise two thresholds for making a judgment of filter clogging, and/or to perform measurement at two timings in order to utilize measurement results for making judgments.

Yet another aspect of the present invention relates to a method of component mounting including procedures for preventing occurrence of defective substrates, which procedures comprising steps of; measuring differential of blowing air pressure blown from the nozzle at an air flow passage at a timing immediately after completion of component mounting operation, which air flow passage is provided for supplying pressurized air to the nozzle; and making a judgment that the component has not been mounted onto the circuit substrate, if the differential of blowing air pressure decrease obtained by the measurement is smaller than a predetermined threshold. The above aspect is also possible to be arranged to comprise two thresholds for making a judgment of filter clogging, and/or to perform measurement at two timings in order to utilize measurement results for making judgments.

Yet another aspect of the present invention relates to a method of component mounting including procedures for preventing occurrence of defective substrates, which procedures comprise steps of; measuring either one of blowing air flow volume, differential of blowing air flow volume decrease, blowing air pressure, or differential of blowing air pressure decrease of the air blown from the nozzle at an air flow passage at a timing immediately after completion of component mounting operation, which air flow passage is provided for supplying pressurized air to the nozzle; comparing the result of the measurement with a predetermined corresponding threshold; making a judgment that the component has been separated from the nozzle and mounted onto the circuit substrate properly, if the blowing air flow volume or the differential of blowing air pressure decrease is bigger than the corresponding predetermined threshold, or the differential of blowing air volume decrease or blowing air pressure is smaller than the corresponding predetermined threshold, and then performing next round component pick up operation; making a judgment that the component has not been separated from the nozzle and that the circuit substrate is missing the component, if the blowing air flow volume or the differential of blowing air pressure decrease is smaller than the corresponding predetermined threshold, or the differential of blowing air volume decrease or blowing air pressure is bigger than the corresponding predetermined threshold; stopping the component mounting apparatus; checking the nozzle, removing the component carried by the nozzle, and confirming that the nozzle is in a proper condition; and restarting the component mounting apparatus for next round component pick up operation.

The above method may also be arranged to comprise two thresholds, and the procedures comprise steps of making a judgment whether a filter disposed at an air flow passage is clogged or not, in addition to making a judgment whether the component has been mounted or not. The procedures may also be arranged to perform the above measurement at two different timings, and utilize the measurement result for making the above described judgments.

Another aspect of the present invention relates to a component mounting apparatus comprising: component supply for supplying component continuously; a mounting head having nozzles for picking up components from the component supply by means of air sucking effect, and separating and mounting the components onto predetermine respective mounting positions of a circuit substrate by means of air blowing effect; a substrate holder for transporting and positioning the circuit substrate; an air sucking/blowing mechanism connected to the nozzles for providing air sucking effect and air blowing effect to the nozzle; and a controller for controlling overall operations of the component mounting apparatus, in which the air sucking/blowing mechanism further comprises: either one of a measuring meter capable of measuring blowing air flow volume or differential of the blowing air flow volume, or a pressure meter capable of measuring blowing air pressure or differential of the blowing air pressure, either one of which is disposed at an air flow passage for supplying pressurized air to the nozzle, and for measuring either blowing air volume or pressure at a timing immediately after completion of blowing air; and a controller for comparing the measuring result obtained by either one of the meters with a corresponding preliminary inputted threshold, and for making a judgment whether or not the component has been mounted properly.

The above described component mounting apparatus may be arranged to comprise two thresholds, and the controller may be designed to make a judgment whether or not the component has been mounted properly or not based on comparison between the measurement result and the first threshold, and/or making judgment either the component has been mounted onto the circuit substrate but the filter is clogged, or the component has not been mounted onto the circuit substrate based on comparison between the measurement result and the second threshold.

The above described component mounting apparatus may be arranged to measure either one of blowing air flow volume, differential of blowing air flow volume decrease, blowing air pressure or differential of' blowing air pressure decrease at two different timings immediately after air blowing operation; and the controller may be arranged to make a judgment whether or not the component has been properly mounted onto the circuit substrate based on comparison between the first measurement result and the corresponding first threshold, and making a judgment either the a filter disposed at air flow passage is clogged, or the component has not been mounted, based on comparison between the second measurement value and the corresponding second threshold.

As described above, according to the procedures of detecting a nozzle without holding a component of the present invention, the component mounting apparatus having a plurality of nozzles connected to a single vacuum generating source may prevent occurrence of defective circuit substrates due to component loss which may be reliably detected without being affected by variance of achieved vacuum pressure after component pick up. According to the present invention, it is also possible to provide sufficient sucking power for sucking and holding a larger component, since a single vacuum source which generates higher vacuum pressure may be used. A single vacuum source arrangement may contribute to reduced cost, too.

Furthermore, according to the procedures of detecting component carry back by the nozzle of the present invention, it is possible to prevent occurrence of defective circuit substrates by detecting component carry back immediately after completion of component mounting operation. Therefore, according to a method and/or apparatus for mounting components of the present invention, it becomes possible not only to prevent occurrence of defective circuit substrates due to misjudgment of component carry back, but also to improve productivity by avoiding sucking problems at component pick up stage due to interference by a component which has been carried back by the nozzle. It becomes also possible to prevent component pick up failure and to improve component mounting quality by preventively detecting clogging of a filter disposed in the nozzle.

### Brief Description of Drawings

Fig. 1 shows a perspective view of an embodiment of the component mounting apparatus according to the present invention,
Fig. 2 shows a block diagram of a control system used for the component mounting apparatus shown in Fig. 1,
Fig. 3 shows a circuit diagram of air pressure system used for the nozzle of the mounting head,
Fig. 4 shows connecting relations between nozzles and vacuum line,
Fig. 5 shows a flow chart of procedures for component loss detection according to the present invention performed under the control of a controller,
Fig. 6 shows an operation performed by a mounting head,
Fig. 7 shows an effect achieved by initializing the achieved vacuum to zero,
Fig. 8 shows a principle for making a judgment whether a nozzle is holding a component or not based on an absolute value of achieved vacuum pressure,
Fig. 9 is a block diagram showing a structure of air sucking/blowing system used for another embodiment of a component mounting apparatus according to the present invention,
Fig. 10 shows an outline of mounting failure detection procedures by means of the air sucking/blowing system shown in Fig. 9,
Fig. 11 shows another aspect of mounting failure detection procedures shown in Fig. 10,
Fig. 12 is a flowchart showing mounting failure detection procedures shown in Fig. 11 to be performed under control of a controller,
Fig. 13 is a flowchart showing alternative mounting failure detection procedures shown in Fig. 12,
Fig. 14 shows an alternative aspect of the mounting failure detection procedures shown in Fig. 11,
Fig. 15 shows yet another alternative aspect of the mounting failure detection procedures shown in Fig. 11,
Fig. 16 is a flow chart showing mounting failure detection procedures to be processed by the controller,
Fig. 17 is a flow chart showing procedures to be processed by the controller at an alternative aspect of the mounting failure detection procedures as shown in Fig. 11,
Fig. 18 shows outline of a method for detecting component loss in prior art, and
Fig. 19 shows a method of detecting mounting failure due to component carrying back in prior art.

### Best Mode for Carrying Out the Invention

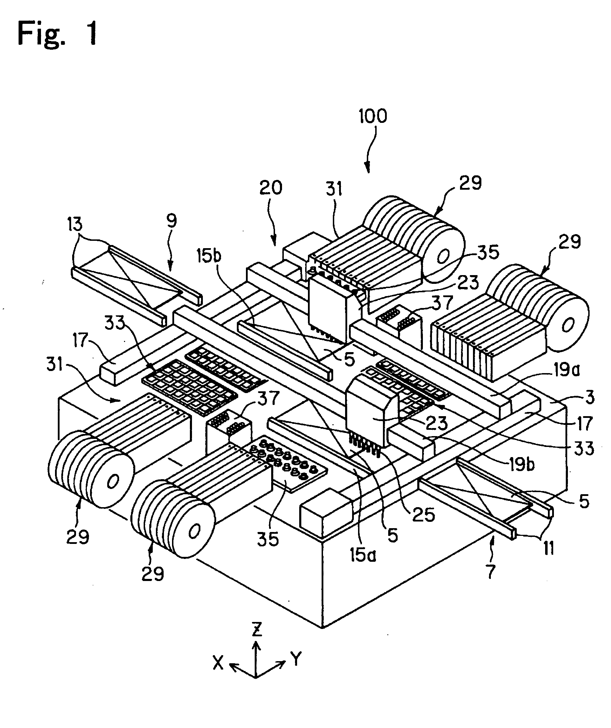

Preferred embodiments of a method and apparatus for mounting components according to the present invention will now be described by referring to appended drawings. The first embodiment of the present invention relates to a method and apparatus of mounting components having procedures or means for detecting component loss by the nozzles. Fig. 1 shows an overall view of a component mounting apparatus according to the present embodiment. Referring to Fig. 1, the component mounting apparatus 100 has a loader 7 for loading circuit substrates 5 into the component mounting apparatus 100, which is located at right hand side in X direction of basement 3. Opposing to the loader 7 at left hand side in X direction, the component mounting apparatus 100 has an unloader 9 for unloading circuit substrates from the component mounting apparatus 100. Each of the loader 7 and unloader 9 has a pair of guide rails 11 and 13 respectively arranged for transporting the circuit substrate 5.

A first substrate holder 15a having support rails for transporting the circuit substrate 5 is provided to the basement 3 facing to the loader 7. Similarly, a second substrate holder 15b having support rails for transporting the circuit substrate 5 is provided to the basement 3 facing to the unloader 9. The component mounting apparatus 100 shown in Fig. 1 comprises two mounting stages connected with each other in series, and mounting operations may be performed on two circuit substrates 5 simultaneously at these two stages.

A pair of Y axis robots 17 are disposed along Y axis at both ends of the basement 3 in X direction. First X axis robot 19a and second X axis robot 19b are mounted on both Y axis robots 17 so as to be moved in Y direction horizontally. Mounting heads 23 are mounted on both X axis robots 19a and 19b respectively, which mounting heads 23 may be moved in X-Y directions and positioned in mounting operation area. These X axis robots 19a and 19b as well as Y axis robots 17 constitute a XY robot 20, which is a transportation means for moving the mounting head 23 in both X and Y directions together with a driving mechanism, e.g., ball screw and nut, or belt driver.

A plurality of nozzles 25 which function as sucking and holding means for holding components are detachably attached to each mounting head 23. Component supplies 31 are formed at both ends of the basement 3 in Y direction. The component supplies 31 may detachably hold component supply devices 29, such as component cassettes. Part trays 33 are also provided in the vicinity of the component supplies 31, which may be used for supplying larger components (e.g., connectors or ICs such as ball grid allay (BGA) or quad flat package (QFP)). Also in the component mounting area close to the component supply 31, nozzle station 35 is provided for stocking a variety of nozzles to be replaced upon necessity.

Recognition camera 37 is positioned in the vicinity of the component supply 31 for imaging a component held by the nozzle 25. Also provided inside the component mounting apparatus 100 is a controller for recognizing and controlling the component supply device 29. A monitor such as liquid crystal panel or CRT, indicating means such as warning lump, inputting means such as touch panel or key board are also provided at the front side of the component mounting apparatus 100.

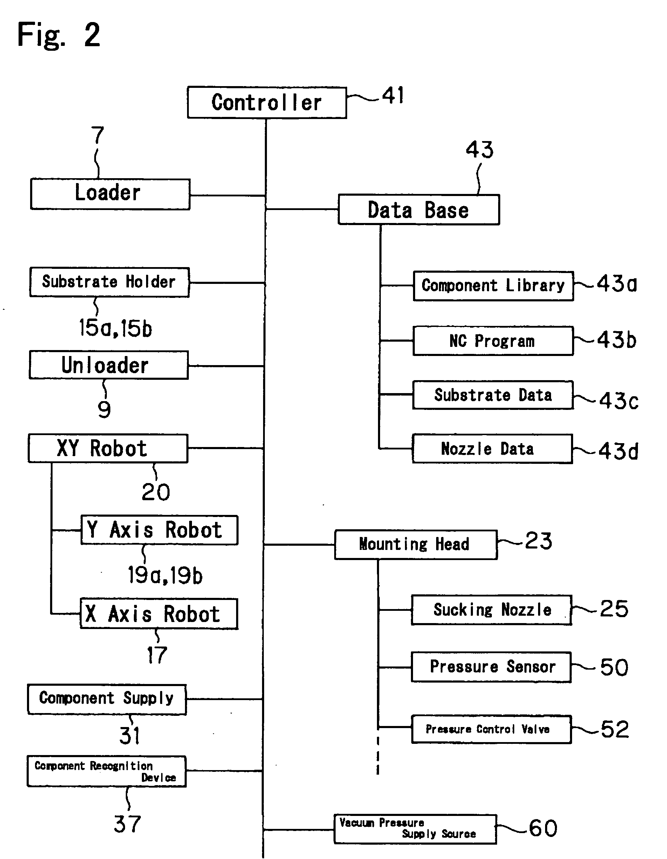

Fig. 2 is a block diagram showing electric control system for controlling major elements of the component mounting apparatus 100 shown in Fig. 1. Referring to Fig. 2, the controller 41 is electrically connected with major elements such as loader 7, substrate holder 15 (including the first and second substrate transport rails 15a and 15b), unloader 9, XY robot 20 comprising X axis robots 17 and Y axis robots 19a and 19b, component supply 31, and component recognition device (recognition camera) 37. The controller 41 is also connected with data base 43, driving system of mounting head 23, electromagnetic valves of the nozzles 25, pressure sensor 50, pressure control valve 52, vacuum pressure supply source 60, etc. In the database 43, data such as component library 43a, NC program 43b, substrate data 43c and nozzle data 43d, etc. are stored.

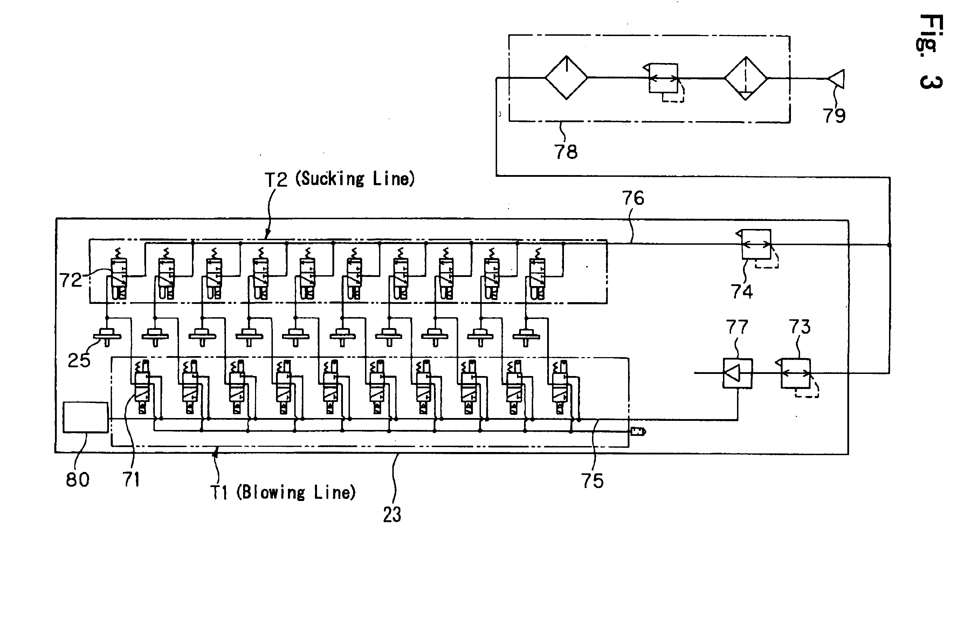

Fig. 3 is a circuit diagram showing a structure of air pressure control system used for the nozzles 25 attached to the mounting head 23. The mounting head 23 is provided with first electromagnetic valves 71 for sucking system T1 and second electromagnetic valves 72 for blowing system T2 for respective nozzles 25. Each nozzle 25 is connected to vacuum line 75 via the first electromagnetic valve 71, and also connected to blowing line 76 via the second electromagnetic valve 72. Sucking system T1 is provided for sucking and picking up a component with the nozzle 25, and blowing system T1 is provided for separating the component from the nozzle 25 when mounting the component onto the circuit substrate.

Negative pressure (vacuum) in the vacuum line 75 and positive pressure in the,blowing line 76 are both generated by a single air pressure source (air blower) 79 having air pressure control unit 78. Namely, upstream of the blowing line 76 is directly connected to the air pressure control unit 78 through a regulator 74, and pressurized air outputted from the air pressure control unit 78 is directly supplied to the blowing line 76. On the other hand, upstream of the vacuum line 75 is connected to the air pressure control unit 78 via an ejector 77 and a regulator 73. Vacuum pressure may be generated by blowing pressurized air into the ejector 77, and generated vacuum is supplied to the vacuum line 75. In other wards, the air pressure control unit 78 and air supply source 79 are commonly used as a vacuum supply source as well as a pressurized air supply source.

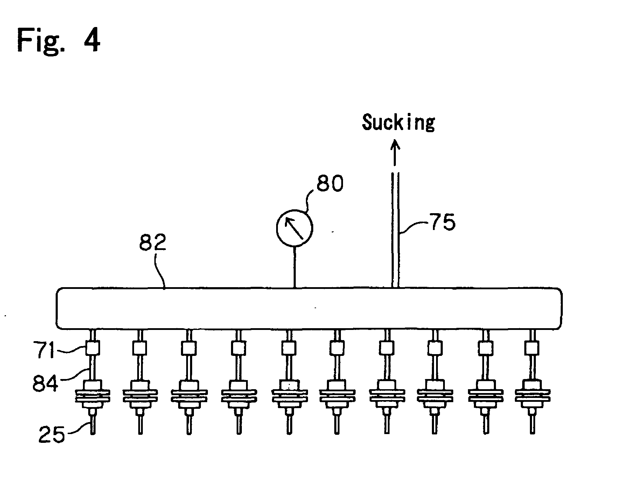

A pressure sensor 80 is connected to the vacuum line 75 for detecting vacuum pressure. As shown in Fig. 4, vacuum air passage 84 of the nozzle 25 is connected to the vacuum line 75 through manifold 82, and the first electromagnetic valve 71 described above is provided for controlling sucking operation in the vacuum air passage 84, which valve 71 may open and close the vacuum air passage 84. A plurality of nozzles 25 are arranged linearly along the manifold 82, and the pressure sensor 80 is positioned around the center of the nozzle arrangement of the manifold 82. This arrangement may prevent the pressure sensor 80 from being affected by local pressure change due to component pick up failure by any one of the nozzles 25.

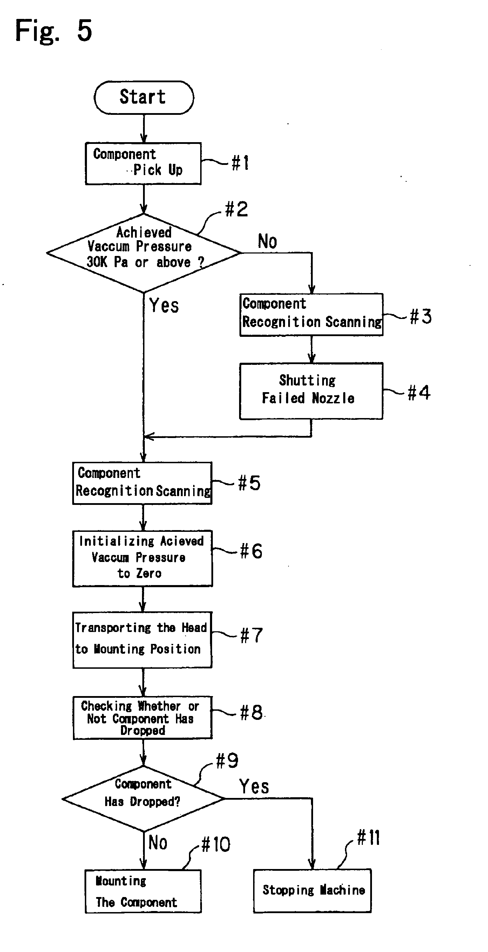

Now a method for mounting components comprising procedures for detecting component loss to be performed at controller 41 (see Fig. 2) is described. In this component mounting apparatus 100, a plurality of nozzles 25, which are connected to a single vacuum generating source through the vacuum line, pick up and hold components and then mount the same on the predetermined position of a circuit substrate. Sequence of such operations is to be described by referring to a flow chart shown in Fig. 5.

After the process flow starts, the mounting head 23 moves to the component supply 31, and the nozzle 25 attached to the mounting head 23 picks up a component at step #1. When sucking a component, vacuum pressure is introduced to the nozzle 25 through the vacuum line 75 by operating the first electromagnetic valve 71 provided to each nozzle 25. Wait for a while until vacuum pressure in vacuum line 75 becomes stable after sucking a component by the nozzle 25, and when the vacuum pressure becomes stable, a value of vacuum pressure is detected by the pressure sensor 80. At step #2, the detected value or the achieved vacuum pressure (absolute value) is checked whether it is higher than a predetermined threshold (second threshold, as an example here, 30kPa).

When the achieved vacuum pressure is less than the threshold or 30kPa, it may be judged that at least any one of the nozzles has failed to pick up a component, and vacuum is leaking from that particular nozzle. In this circumstance, component recognition scanning is performed at step #3. More specifically, the mounting head 23 is moved to the position where the recognition camera 37 is located, and when the mounting head 23 passes over the recognition camera 37, each of the nozzles 25 are imaged. The nozzle 25 that has failed to pick up a component may be identified based on the imaged data. When such failed nozzle 25 is identified, the first electromagnetic valve 71 of that particular failed nozzle 25 is shut so as to prevent air leakage. Through such procedure, vacuum pressure in the vacuum line 75 may be recovered, and stable vacuum pressure condition at other nozzles 25 may be achieved.

Through performing procedures of steps #3 and #4 as described above, the negative effect caused by component loss at component pick up stage may be resolved. When the achieved vacuum pressure after component pick up operation is more than 30kPa at step #2, or when performing the procedure at step #4 has been completed even after lower than 30kPa of achieved vacuum pressure has been detected, the flow goes to step #5 where component recognition scanning is performed. Namely, each nozzle 25 is imaged by the camera 37 when the mounting head 23 passes over the recognition camera 37, and condition of each nozzle 25 is recognized based on the imaged data. Component loss due to movement of the mounting head 23 may be detected through these procedures.

At step #6, the achieved vacuum pressure is initialized to zero, and then at step #7, the mounting head is moved to a position where mounting operation is to be performed. Then, possible component loss which may occur after the procedures of identifying failed nozzle 25 is detected at step #8, and judgment as to whether any component is lost or not is made at step #9.

The procedures for making a judgment whether or not a component is lost are as follows. Vacuum pressure decrease from the initialized zero point (relative value) at nozzle 25 is measured, and if the measured pressure decrease is bigger than the predetermined first threshold, it may be judged that component has been lost. In such a case, at least this particular failed nozzle 25 is arranged to skip component mounting operation. One possible way is to stop the component mounting apparatus (step #11). On the other hand, when vacuum pressure decrease from the initialized zero is smaller than the first threshold, it may be judged that the is not component lost and that scheduled component mounting operation may be performed (step #10).

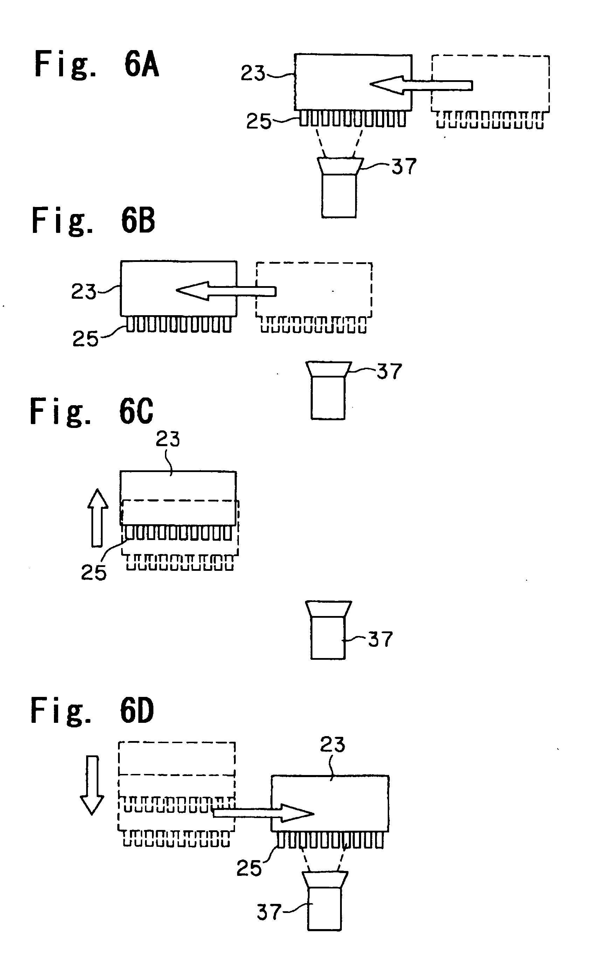

Figs. 6A-6D show relations between movement of the mounting head 23 and the recognition camera 37. Referring to Fig. 6, after completion of component pick up operation, the mounting head 23 moves over the recognition camera 37 as shown in Figs. 6A and 6B, and during such movement, condition at each nozzle 25 is imaged and recognized by the camera 37. When the achieved vacuum pressure after completion of component pick up operation is lower than 30kPa, the failed nozzle 25 or the nozzle 25 that has failed component pick up is identified. In this case, vacuum passage to the failed nozzle 25 is shut so that vacuum pressure in the vacuum line 75 may be recovered.

Next, the mounting head 23 is raised to normal height as shown in Fig. 6C, and the head 23 is moved toward a position where a circuit substrate is located, during which timing such height is normally maintained. However, there is a possibility that a component held by the nozzle 25 may be lost due to, for example, movement shock of the mounting head 23. If a component is lost, this may be detected, as explained above, by measuring vacuum pressure decrease, since there should be vacuum pressure decrease from the initialized achieved vacuum pressure (base=zero) due to component loss. When component loss is found, one possible solution may be stopping the component mounting apparatus as described above, but another possible way is to move the mounting head 23 over the recognition camera 37 one more time as shown in Fig. 6D, and to identify from which nozzle 25 a component has dropped. Through such procedures, it becomes possible to perform component mounting operation by the nozzles 25 other than by the identified failed nozzle 25.

As explained above, the controller 41 makes two kinds of judgment based on detected vacuum pressure. One judgment is to find out, by using the achieved vacuum pressure as an absolute value, component pick up failure at component pick up stage based on whether or not the absolute value is bigger than the second threshold (30kPa). Another judgment to be made is to find out, by using initialized achieved vacuum pressure after completion of component pick up operation, component loss from the nozzle during movement of the head 23 based on whether or not the relative vacuum pressure decrease from the base value (zero) is bigger than the first threshold value.

For these reasons, analog outputs to be transmitted to the controller 41 are inputted into two separated channels CH1 and CH2 disposed on the controller 41, and the outputs are processed both at CH1 and CH 2, separately.

In the process performed at CH1, the achieved vacuum pressure is initialized to zero after vacuum becomes in stable condition. Through this procedure, the pressure achieved at completion of component pick up operation under any sucking conditions would be initialized to zero, thereby variance of achieved vacuum pressure after component pick up would not cause any influence upon future detection. Under such condition, if air leakage due to component loss occurs and vacuum pressure change due to such leakage becomes bigger than the first threshold (10kPa, for example), it may be judged that a component is lost, and an alarm signal may be generated for warning an operator. In brief, any changes of component condition after completion of component pick up operation may be monitored through the process performed at CH1. If component loss is detected during the course, as stated above, it may be possible either to stop the component mounting apparatus or to skip component mounting operation with that particular failed nozzle.

In the process performed at CH2 on the other hand, the achieved pressure after completion of component pick up operation would not be initialized to zero, but rather the achieved pressure is monitored as an absolute value. If the achieved vacuum pressure after completion of component pick up operation is lower than' the predetermined second threshold value (30kPa, for example), the controller transmits a signal to warn that sucking power is low. In brief, pressure condition after completion of component pick up is monitored in the process performed at CH2.

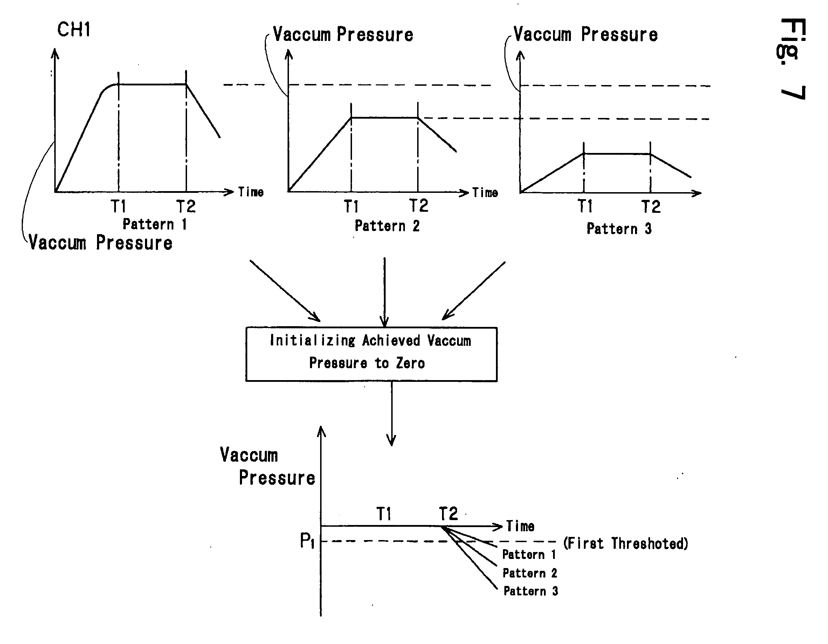

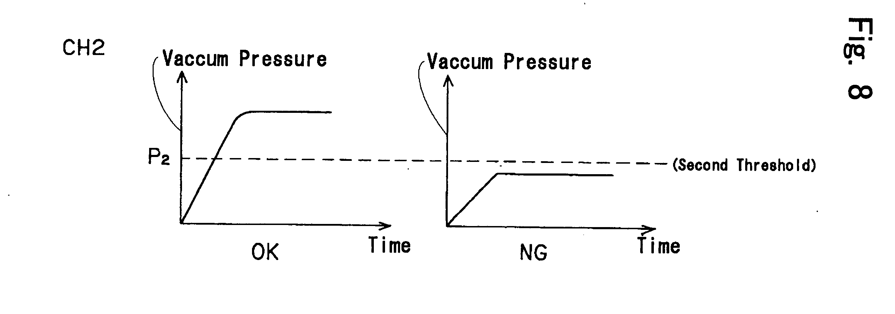

The above mentioned effects will be explained in more detail by referring to Figs. 7 and 8. Vacuum pressure pattern during component pick up may vary depending upon configuration of component etc., hence achieved vacuum pressure may vary as exemplarily shown in pattern 1-3 in Fig. 7. However, if the achieved vacuum pressure is initialized to zero, and by checking pressure change (vacuum pressure decrease) base on that initialized standard, component loss may be detected by using a single threshold P1 without being influenced by such achieved vacuum pressure variance.

When component loss is detected based on such relative vacuum pressure change, it becomes possible to prevent occurrence of defective substrate by simply skipping component mounting operation by that particular failed nozzle 25. Furthermore, when component loss is detected, component mounting operation by the nozzles 25 other than that particular failed nozzle 25 may by performed, whereby unnecessary waste of components held by the nozzles without failure may be saved if the failed nozzle 25 is identified through performing recognition process again.

In the process performed at CH2 as shown in Fig. 8, achieved vacuum pressure at completion of component pick up operation is detected as an absolute value, and whether component pick up is properly performed (OK) or not (NG) may be judged by comparing measurement value with the second threshold P2 (e.g., 30kPa), hence countermeasure may be taken instantly. That is, the nozzle 25 that failed component pick up and vacuum air is leaking may be identified by imaging the nozzles 25 with the recognition camera 37, and the vacuum air passage 84 of that identified failed nozzle 25 may be shut so as to recover overall vacuum pressure.

The above mentioned first threshold (:10kPa) and second threshold (:30kPa) used at CH1 and CH2 may be determined at any appropriate values by considering achieving pressure of the vacuum pressure supply and/or routing of pipes etc. As the second threshold is to be determined based on relations between the achieved vacuum pressure and a number of component losses as shown in Fig. 8, it would be preferable to set the second threshold at around 30kPa level. If the threshold is set lower than this level, it would be difficult to identify a number of component losses due to minimized pressure change corresponding to a number of component losses.

It may be possible to provide an orifice in the vacuum air passage 84 for protecting air leakage from the failed nozzle 25. In this case, smaller area of air flow in the orifice helps preventing rapid pressure decrease.

Now the second embodiment of a method and apparatus for mounting components according to the present invention having procedure and means for detecting mounting failure and component carrying back by the nozzle after completion of mounting operation will be described by referring to appended drawings. In the following embodiments, the like elements as explained in the first embodiment will bear like reference numerals. Configuration of the component mounting apparatus is basically the same as the one described by referring to Figs. 1-3 in the first embodiment. The following description is basically focused on differences between the present embodiment and the prior art and/or the first embodiment.

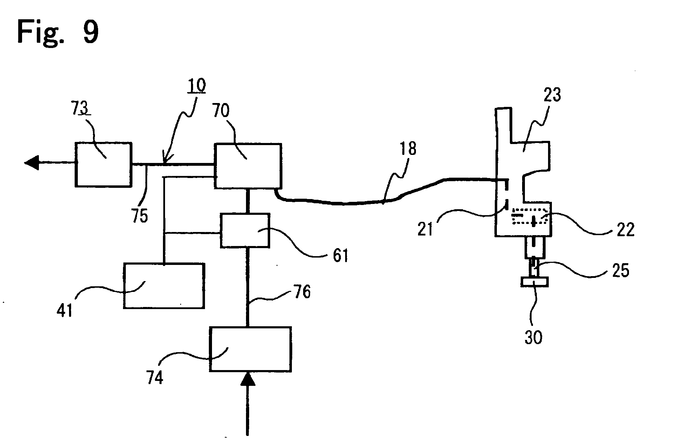

Fig. 9 shows outline of an air sucking/blowing mechanism 10 of the present embodiment, which may be used for supplying vacuum pressure to the nozzle 25 for sucking a component, and pressurized air to the nozzle 25 for separating a component. The air sucking/blowing mechanism 10 is designed to provide the nozzles 25 of the mounting head 23 with sucking/blowing effect. The air sucking/blowing mechanism is connected to a nozzle 25 through a connection tube 18. Referring to Fig. 9, the air sucking/blowing mechanism 10 comprises: a regulator 73 (which includes the ejector 77 as shown in Fig. 3) to be connected to vacuum line 75 for supplying vacuum pressure to opening of the nozzle 25 during component sucking; a regulator 74 to be connected to blowing line 76 for supplying pressurized air to the opening of the nozzle 25; a switching means 70 such as electromagnetic valve for selectively switching the passage to the nozzle 25 between the vacuum line 75 and the blowing line 76; and a controller 41 for providing switching operation command to the switching means 70 in synchronism with component, mounting operation. The controller 41 may be integrated into the controller of the component mounting apparatus, or may be separated in which case controlling operation of the controller 41 needs to be in synchronism with operations of the component mounting apparatus. The regulators 73 and 74 are connected to the air pressure source 79 through air pressure control unit 78 as shown in Fig. 3.

In the mounting head 23, an air flow passage 21 is provided for connecting the connecting tube 18 and the nozzle 25, and a filter 22 for filtering dusts or debris is placed in the air flow passage 21. A component 30 is picked up by the nozzle 25 with the sucking effect of vacuum which is provided through the vacuum line 75, and when mounting the component, the switching mechanism 70 switches connection of the nozzle to the blowing line 76 so that the component 30 may be separated from the nozzle 25 with positive air pressure generated by blowing air through blowing line 76.

In the air sucking/blowing mechanism 10 of the present embodiment, measuring meter 61 for measuring blowing air flow blown from the nozzle 25 through the blow line 76 is attached to the blowing line 76, which is a passage for blowing air between the regulator 74 and the switching, mechanism 70. The controller 41 provides a command to the measuring device 61 to measure the blowing air blow volume at appropriate timing, in addition to providing a command to the switching means 70. Further, measuring data obtained by the measuring meter 61 is transmitted to the controller 41, and the controller 41 compares the data with the preliminarily inputted threshold for making necessary judgment.

Although only one nozzle 25 is shown in Fig. 9, the vacuum pressure supply source and the pressurized air supply source may be commonly used by a plurality of nozzles which are attached to a single mounting head. The switching means 70 and the measuring meter 61 are to be provided for each nozzle 25 separately. In Fig. 9, the mounting head 23 and the air sucking/blowing mechanism 10 are shown in separated positions, but they may be integrated into the mounting head 23 as shown in Fig. 3. Further, single switching means (electromagnetic valve) 70 performs switching operation between vacuum pressure and positive pressure in the illustrated example in Fig. 9, but this may be arranged in a similar manner as shown in Fig. 3 where both vacuum line and pressurized line have independent electromagnetic valves 71 and 72.

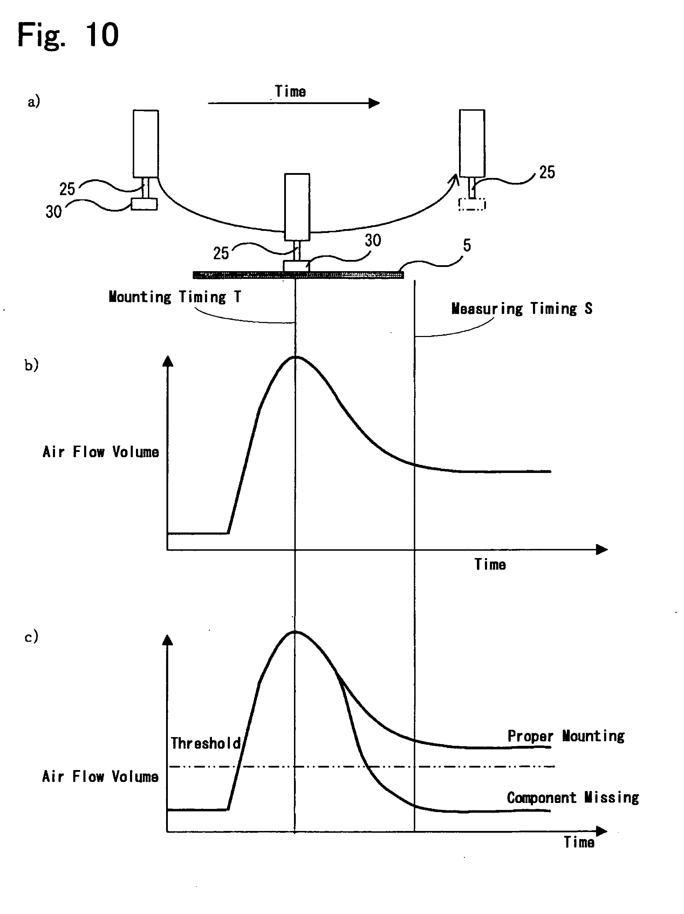

Now a method for detecting mounting failure (component carrying back) according to the present embodiment using the air sucking/blowing mechanism 10 as described above will be explained by referring to Figs. 10A-10C. Fig. 10A shows movement of the nozzle 25 during the time elapse indicated in horizontal axis. In the drawing, the nozzle 25 transports the picked up component 30 by movement of the mounting head 30, and after stopping at the position opposing to a circuit substrate 5, the nozzle 25 descends against the circuit substrate 5. The circuit substrate 5 is firmly placed at its position. The nozzle 25 reaches at its lowest position at the mounting timing T, which is shown in the middle of the horizontal axis, and mounts the component 30 onto the circuit substrate 5. After completion of component mounting, the nozzle 25 moves upward and returns to the original position.

Fig. 10B shows blowing air flow volume (in vertical axis) flown through the nozzle 25 (hence through measuring meter 61 shown in Fig. 9) during time elapse corresponding to movement of the nozzle 25 (horizontal axis) as shown in Fig. 10A. The nozzle 25, which has been holding the component 30 with sucking effect through vacuum line 75, separates the component 30 when the switching means 70 of the air sucking/blowing mechanism 10 switches connection of the nozzle 25 to the blowing line 76, and mounts the component 30 onto the circuit substrate 5. Due to such air blowing action, the blowing air flow volume reaches at its peak at mounting timing T, and then air blow volume gradually decreases. The measuring meter 61 provided to the air sucking/blowing mechanism 10 measures blowing air flow volume at measuring timing S as shown in the drawing, and transmits the measured data to the controller 41.

In practice, there is a small time elapse between the time when the nozzle 25 touches the circuit substrate 5 and separates the component 30, and the time when the nozzle completes component mounting and start to ascend (e.g., about 20ms). Also, in order to change vacuum condition of the nozzle 25 for holding the component to positive pressure condition by breaking such vacuum condition, there is also a small time elapse (e.g., about 20ms). These time elapses cause gradual air flow volume increase even before the mounting timing T, as shown in Fig. 10B. Accordingly, actual mounting operation is performed during a time span including such time elapses. In this specification, the timing when the blowing air flow volume reaches at its peak during component mounting operation is referred to as the mounting timing T.

After completion of component mounting, the blowing air flow volume decreases from the peak, and then the air flow volume would saturate at a certain constant level as shown in Fig. 10B. This is because, even after completion of component mounting, air blowing from the nozzle 25 is continued at a certain volume level for the time being (e.g., about 20ms) until the mounting head 23 starts to move for next round component pick up operation. The measuring timing S for measuring blowing air flow volume is determined where the blowing volume saturates at a certain level, or in the vicinity of thereof.

Fig. 10C shows comparison of result of the blowing air flow volume measured by the measuring meter 61 with a predetermined threshold. When the component 30 is separated from the nozzle 25 and mounted properly, the blowing air flow volume changes along the pattern as shown by the curve "proper mounting" in the drawing, and a certain volume of air flow is blown from the nozzle 25 since the opening of the nozzle 25 is completely cleared. On the contrary, if the component 30 is not separated from the nozzle 25 for some reasons, and continued to be held by the nozzle 25, the blowing air flow passing through the nozzle 25 changes along the pattern as shown by the curve "component missing" in the drawing, since the opening of the nozzle 25 is blocked by the component 30 which is still held by the nozzle 25. There is a big gap between the two patters of "proper mounting" and "component missing". The threshold may be determined base on statistic data of such volume difference, and judgment as to whether the nozzle 25 has failed component mounting and is carrying back the component may be made by using the predetermined threshold.

The blowing air flow measuring timing S may be set immediately after the mounting timing T (e.g., within 10ms time interval), as shown in the drawing. According to the present embodiment, the measuring device 61 is disposed at blowing line 76 which is the air flow passage in the air sucking/blowing mechanism 10, and blowing air flow volume may be measured at any timing because it is not required to move the nozzle 25 to a remote position where a measuring device is located as in the case of prior art. Accordingly, it become possible to set measuring timing S far closer to mounting timing T than in the case of prior art. Moreover, no extra spaces are needed for blowing air flow measuring because the measuring meter 61 may be disposed inside the air sucking/blowing mechanism 10, rather than outside of the nozzle 25 as in the case of prior art.

Positioning the measuring meter 61 is not limited to at the blowing line 76 as shown in Fig. 9, and the measuring meter may be disposed at other locations such as at connection tube 18, at air flow passage 21 or at any other air flow passage before it reaches to the nozzle 25.

Some exemplary reasons why the component 30 is not separated from the nozzle 25 are: penetration of cream solder into contacting interface between the nozzle 25 and the component 30 when cream solder is applied to the circuit substrate 5; deposit of adhesive materials on the nozzle 25; condensation of moisture on the surface of the component 30, etc.

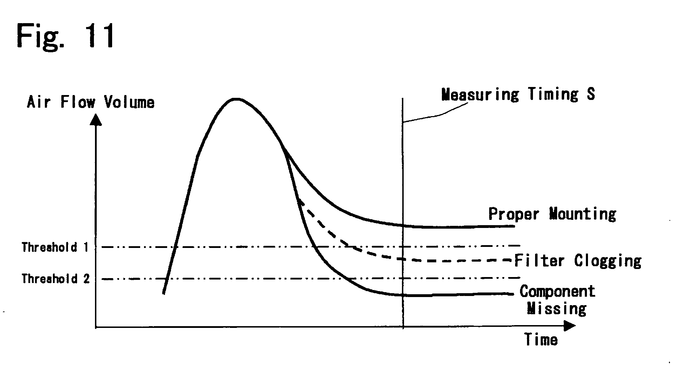

Fig. 11 shows another aspect of the method of detecting mounting failure according to the present embodiment. Fig. 11 basically corresponds to Fig. 10C, but two thresholds 1 and 2 are illustrated in Fig. 11, which may be used for making a judgment not only either "proper mounting" or "mounting failure", but also whether or not the filter 22 (see Fig. 9) associated with the nozzle 25 is clogged.

When dusts or debris are accumulated in the filter 22 located in the air flow passage 21, the air flow volume passing the blowing line 76 is reduced due to blockage of the air flow by such dusts etc. Sizes of these dusts or debris are in µm orders, which are far smaller than the sizes of chip components. Accordingly, blocking effect by the dusts against air flow volume is also significantly smaller than that of the component 30. Therefore, it is possible, by using statistic data, to distinguish whether the blocking effect is caused by clogging of the filter 22 or by remaining component 30. Threshold values 1 and 2 may be determined based on respective statistic data, and they can be used for making a judgment whether the nozzle 25 has "properly mounted" a component, or has failed to mount a component ("mounting failure") or the filter is clogged ("filter clogging").

More specifically, two thresholds 1 and 2 are preliminary determined based on accumulated data, and the blowing air flow volume after completion of component mounting are compared with these two thresholds. If the measuring result is bigger than both of the thresholds 1 and 2, it may be judged that the component has been properly mounted. If the measuring result is smaller than both of the thresholds 1 and 2, it may be judged that the component has not been mounted (mounting failure). In case the measuring result is between the two thresholds 1 and 2, it may be judged that the filter 22 is clogged. The term "proper mounting" used in this specification is to mean that the component is mounted properly by the effect of blowing air flown from the nozzle 25 without having filter clogging, and the term "clogging" is to mean that the filter 22 is under clogged condition. Although it is referred to as "filter clogging" in the above description, it should be understood that clogging of other portion such as clogging of blowing line 76, connection tube 18 or inside the nozzle 25 may also be detected by the same procedures. Therefore, the term "filter clogging" is not limited to clogging of the filter itself, but clogging of other portions like described above is also included.

When component carrying back by the nozzle 25 is detected, the component 30 should be in a condition still being held by the tip of the nozzle 25. If such particular nozzle 25 performs next round component pick up operation, the component 30 still held by the nozzle 25 may interfere the pick up operation. Also, if no counter measures are taken after mounting failure is detected, the circuit substrate 5 would be a defective product due to missing component. Therefore, it is desirable to provide necessary procedures in component mounting operations which may lead to avoid these kinds of undesirable situations.

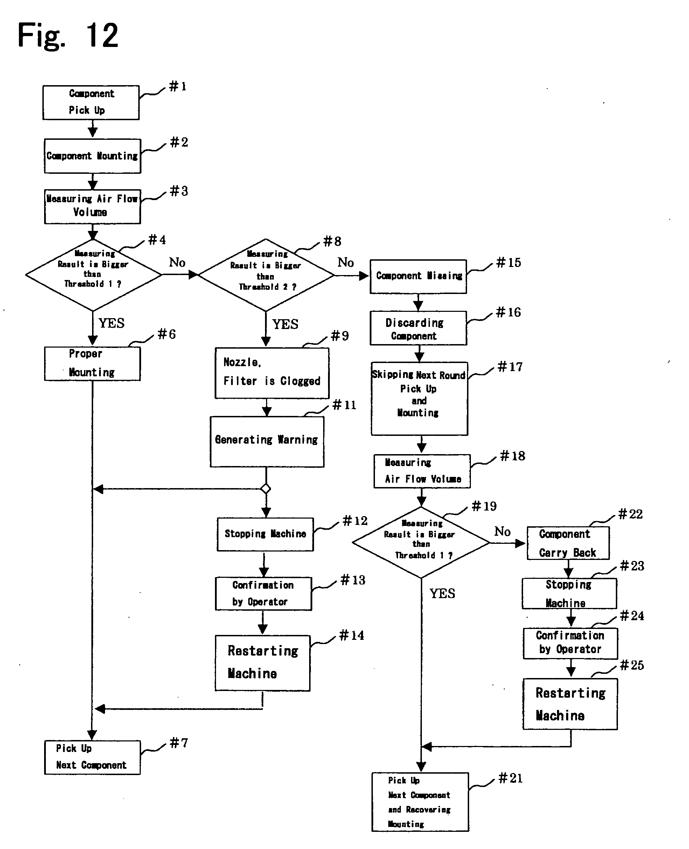

The flow chart of Fig. 12 shows procedures of a method for mounting component having procedures of detecting mounting failure according to the present embodiment, as well as a counter measures for avoiding component pick up failure as described above. The method also has procedures of countermeasures for recovering missing components so as to prevent occurrence of defective circuit substrate. The method of component mounting of the present embodiment is hereinafter described by referring to Fig. 12.

Referring to Fig. 12, a nozzle 25 picks up a component 30 at step #1, and mounts the component 30 onto a circuit substrate at step #2. Blowing air flow volume is measured at step #3, and the measurement value is compared with the threshold 1 at step #4. If the measurement value of air flow volume is bigger than the threshold 1, the component 30 is judged to have been properly mounted as shown in step #6, and, in this case, the process flow goes to step #7 for picking up next component 30, and repeating the procedures from step #2.

If the measurement value is smaller than the threshold 1 at step #4, the process flow goes to step #8, where the measurement value is compared with the threshold 2. If the measurement value is bigger than the threshold 2, it may be judged that the filter is clogged at step #9. In this case, an alarm is generated for warning an operator at step #11, and the flow may go to step #7 for picking up next component 30. As the component 30 is judged to have been properly mounted in this case, it may not cause any problems even if the nozzle 25 with the clogged filter picks up the next component 30. Nevertheless, the operator has an option to stop the component mounting apparatus at step #12, and takes necessary actions such as cleaning or replacing the nozzle 25 and/or filter 22 at step #13. Then the operator may restart the component mounting apparatus at step 14, and the process flow may goes to picking up operation at step #7.

Now back to step #8, if the measurement value of air flow volume is smaller than the threshold 2, it is judged that the component has not been mounted (the nozzle 25 is carrying back the component 30) at step #15. In this case, the component being carried by the nozzle is to be discarded at step #16 so as to avoid causing any problems at next round component pick up operation due to the remaining component 30. Specifically, the nozzle 25 is moved to component discarding position, where high pressure air is blown through that nozzle 25, or the nozzle opening is cleaned by using a blush or the like. In this circumstance, next round component pick up operation is skipped at step #17, and blowing air flow volume is measured again at step #18 in order to re-confirm that the component held by the nozzle has been discarded. If it is confirmed at step #19 that the measurement value is bigger than the threshold 1, which means that the component has been discarded, the flow goes to step # 21 to pick up the next component 30, and mount the same for recovering the missing component during the previous round mounting operation at step #15. These procedures are to be repeated.

If the measurement value at step #19 is smaller than the threshold 1, it is judged at step 22 that the component has not been discarded during the step #16, and that the nozzle is still carrying the component. In this case, the component mounting apparatus is stopped at step #23, and an operator takes necessary actions such as checking and cleaning the nozzle 25 at step #24, and then component mounting apparatus is re-started at step #25. At step #21, the next component is picked up, and then mounted on the same circuit substrate for recovering the missing component.

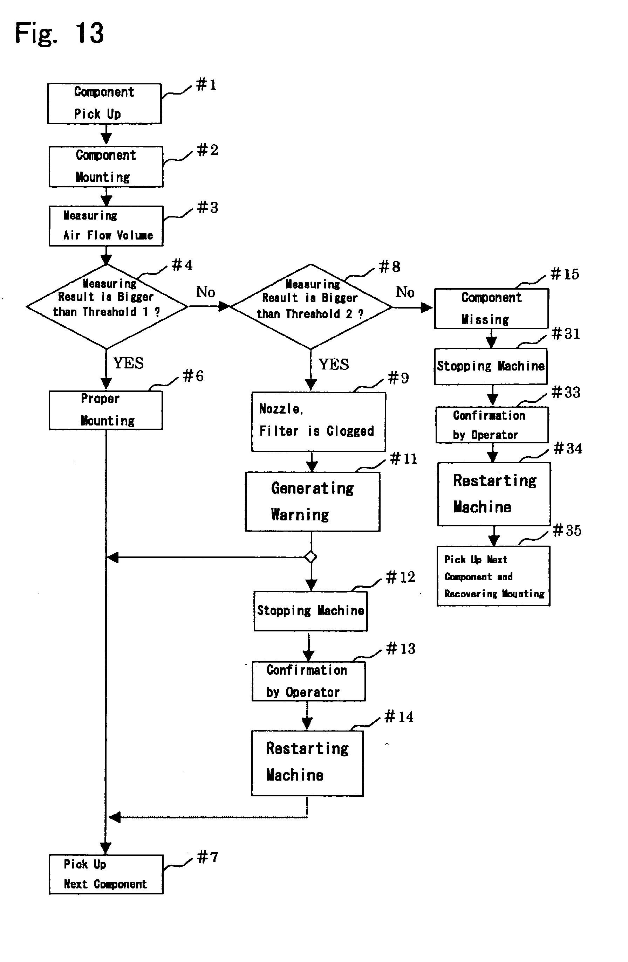

As the flow chart of Fig. 12 shows, it is preferable to re-confirm automatically whether the carried back component has been discarded or not, but alternatively these procedures may also be performed manually, i.e., an operator stops the component mounting apparatus and checks the nozzle visually. Fig. 13 shows a flow chart in which the above confirmation procedures are performed manually. Referring to Fig. 13, steps #1-#14 are the same as the flow chart of Fig. 12. If mounting failure is detected at step #15, an operator stops the component mounting apparatus at step #31. At step #33, an operator visually checks the condition of the nozzle 25, removes the component if it is still being carried by the nozzle 25, and confirms that the nozzle 25 is in proper condition. Then the component mounting apparatus is restarted at step #34, and next component is picked up and then mounted on the circuit substrate for recovering the missing component at step #35.

In case of the flow charts shown in Figs. 12 and 13, two threshold values 1 and 2 as shown in Fig. 11 are used for detecting both mounting failure and filter clogging. In case only the threshold 1 is used as shown in Fig. 10C, all the procedures from steps #8-#14 in Figs. 12 and 13 related to threshold 2 are not necessary. Also in case of the flow charts shown in Figs. 12 and 13, the nozzle 25 which has failed component mounting is arranged to perform a recovering mounting operation by mounting the same component (step #21 or #35), but such recovering may be performed by using a different nozzle, and the nozzle which has failed to mount a component may be used to mount a different component at the next round operation.

Although not shown in the flow chart of Figs. 12 and 13, further procedure for confirming whether the component is actually missing or not may be performed. Such confirmation procedure may be performed by checking the circuit substrate 5 either manually by an operator or automatically by using a recognition means, after component missing is detected at step #15. If component missing is confirmed by such procedure, it may be judged that the nozzle 25 has carried back the component 30. On the other hand, if it is confirmed by this procedure that the component 30 is properly mounted, it may be judged that detection made at step #15 was not correct, and that something wrong with either measuring meter 61, nozzle 25 or filter 22.

As described above, according to the present embodiment, blowing air flow volume of a nozzle 25 immediately after completion of component mounting operation may be measured by means of measuring meter 61 deployed in air sucking/blowing mechanism 10 of a nozzle 25. By this arrangement, phenomena of component carrying back may be reliably detected, without worrying about a space for locating a measuring meter, and with reduced risk of making a misjudgment due to component loss during a time lag between component mounting and measuring. Furthermore, by providing a plurality of thresholds properly, not only defective substrate due to component missing, but also clogging of filter 22 may be detected, hence it becomes possible to take preventive maintenance' actions so as to avoid component picking up failure and/or component mounting failure due to clogging of a nozzle.

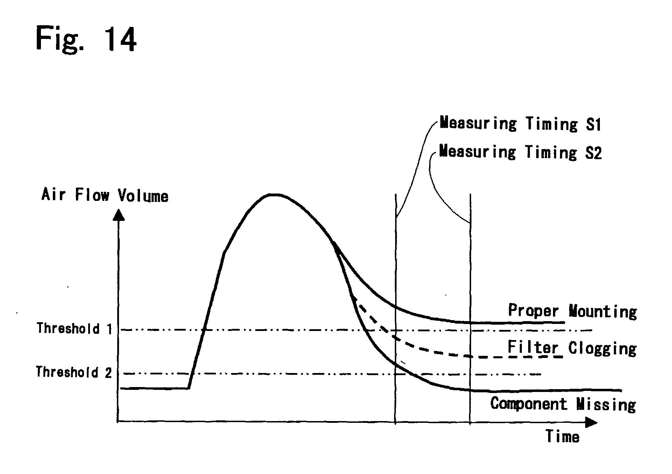

A variety of alternative aspects of the present embodiment of a method for detecting mounting failure due to component carrying back may be conceivable. Fig. 14 shows a first alternative aspect of the present embodiment. In this aspect, blowing air flow from the nozzle 25 is measured at two different timings S1 and S2 immediately after completion of component mounting, for the purpose of improving detection quality.

As described above, component size is becoming smaller and smaller recently, and blowing air flow measurement at measuring timing S (see Fig. 10a) may not be accurate enough for evaluating a difference from the threshold due to small opening area of recent small sized nozzles. It may be especially difficult to distinguish between filter clogging and mounting failure due to so small amount of flowing air volume. One possible solution to overcome this problem may be to delay measuring timing S until the blowing air flow becomes stable and such air flow difference becomes clearer. However, if the measuring timing S is delayed, the timing gap between mounting timing T and measuring timing S would be longer, and this may cause negative effects such as lengthening of operational cycle time due to the delayed timing, or increasing risk of making a misjudgment due to component missing during such time gap.

A method of detecting mounting failure and/or nozzle clogging according to the present embodiment may resolve those problems. Referring to Fig. 14, first blowing air flow measurement is performed at measuring timing S1 immediately after the nozzle 25 has completed component mounting by means of air blowing. By comparing the result of measurement of the blowing air flow obtained at measuring timing S1 with the predetermined threshold 1, whether the component 30 is properly mounted on the circuit substrate 5 or not is detected, first. As shown in the drawing, "proper mounting" may be detected even at such early measuring timing S1 immediately after air blowing operation, because blowing air flow volume is relatively large in the case of "proper mounting" compared to other cases. It is also possible to reduce a risk of making a misjudging due to component loss because measuring may be done at such an early timing after component mounting operation.

Then, the second measurement of the blowing air flow volume is conducted at measuring timing S2, in which the nozzle 25 has completed mounting operation and starts to move upward. The tip of the nozzle 25 at this timing is completely in cleared condition. Since the blowing air flow at the measuring timing S2 is stable, it is relatively easy to identify in which area the blowing air flow volume is to be categorized. By comparing the measurement result with the threshold 2 at this timing, it may be identified the reason why it was judged not properly mounted at the first measuring timing, either because of "mounting failure" or because of "filter clogging". Event this second measuring timing is much closer to mounting timing T compared to prior art, because moving the nozzle toward the detecting device or flow measuring meter is not required. Accordingly, it becomes possible to reduce a risk of making a misjudgment due to component loss during such movement.

The procedures of the present embodiment are substantially the same as the flow chart shown in Fig. 12 and 13, except blowing air flow volume is measured at two different timings. Even for the case where a small component (e.g., chip component having a span length of less than 1.0 mm) is to be mounted, or the case where small nozzle is used, an accurate judgment may be made whether the result situation is "proper mounting", "nozzle clogging" or "mounting failure" by measuring blowing air flow at two different timings. This may help preventing occurrence of defective substrate and improving quality of component mounting operation.

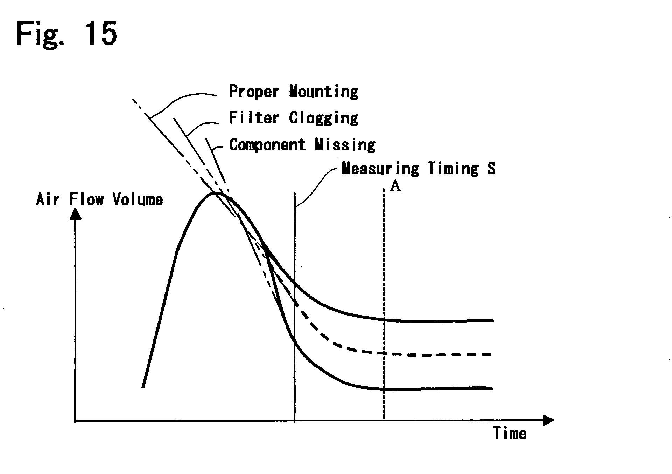

Fig. 15 shows a second alternative aspect of the present embodiment, in which variance of blowing air flow volume is measured instead of blowing air flow volume. In this aspect, the measuring meter 61 of the air sucking/blowing mechanism 10 shown in Fig. 9 is designed to calculate variance (differential or derivative) of blowing air flow volume by measuring blowing air flow volume for a certain length of time and processing the obtained data. Other structure of the air sucking/blowing mechanism 10 is the same as those described above.

The pattern of blowing air flow passing through the nozzle shown in Fig. 15 is the same as the one shown in Fig. 11. In this aspect of the embodiment, the measuring meter 61 deployed at blowing line 76 calculates differential of the blowing air flow passing through the nozzle 25 at measuring timing S, which is immediately after completion of component mounting. Blowing air flow volume at such measuring timing S is in decreasing stage after mounting operation, hence the differential (derivative) of the blowing air flow may be shown in downgrading inclination in a graph. When illustrating such inclination measured at appropriate measuring timing S, as shown by divided lines with two dots in Fig. 15, the inclination for the case of "proper mounting" is relatively gentle, since air flow from the nozzle is quite easy after separation of the component, the inclination for the case of "mounting failure" is relatively steep, since blowing air flow decreases rapidly due to blockage by the held component. In case the component has been mounted but the nozzle is clogged, the level of inclination will be medial between the two previous inclinations.

By inputting such inclinations into the controller 41 as thresholds (not show in the drawing), judgment may be made either the case is to be categorized in "proper mounting", "nozzle clogging" or "mounting failure" by comparing calculated inclination (derivative) of the case with these, thresholds. Although two thresholds are used for detecting not only "mounting failure" but also "filter clogging" in Fig. 15, single threshold may also be used for detecting "mounting failure" only. In addition, Fig. 15 shows a case the blowing air flow is measured at only one measuring timing S, but measuring blowing air flow at two different timings as shown in Fig. 14 may also be possible for the purpose of improving measurement accuracy.

Dotted line A in Fig. 15 shows.a second measuring timing in the case of the embodiment shown in Fig. 11. As is explained before, if blowing air flow volume itself is used as a basis for making judgment, certain time span is needed to wait until the time when air flow becomes stable. On the contrary, according to the present embodiment where differential of blowing air flow volume is used, measurement timing S may be set even closer to mounting timing T, and this may help avoiding making a misjudgment due to component loss during such timing gap, and improving component cycle time.

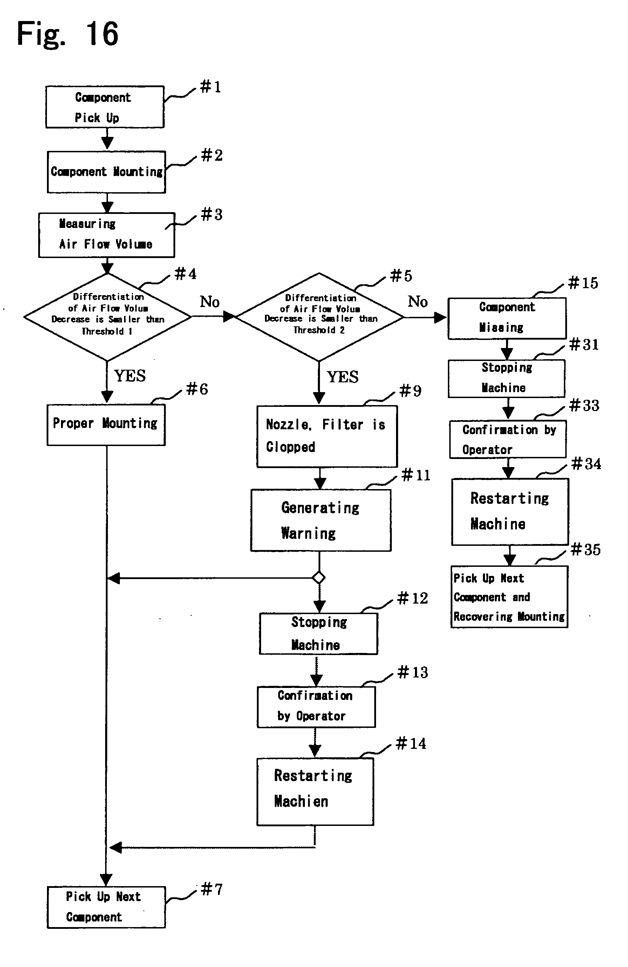

Flow chart of Fig. 16 shows procedures of the alternative aspect of the present embodiment as described above. The procedures shown in Fig. 16 are basically similar to those of the flow chart shown in Figs. 12 and 13. The difference lies in that differential of blowing air flow rather than blowing air flow is measured at step #3. Also in step #4 and #5, obtained differential of air flow (inclination of air flow decrease) is compared with thresholds 1 and 2, and judgment is made whether the obtained differential is smaller or not than the thresholds 1 and 2, rather than bigger or not as in the case of previous embodiment. Other procedures are the same as those of the previous embodiment.

As explained before, the component mounting apparatus in prior art generally adopts a system in which blowing air flow continues for a while after completion of component mounting until the time the mounting head 23 starts to move. Recently, in some type of component mounting apparatus, it is designed to shut such wasting of unnecessary air blowing at earlier timing by adding an electromagnetic valve. According to the present embodiment, mounting failure may be detected even in such type of component mounting apparatus, since detection may be performed at very early stage immediately after component mounting, and waiting for stable air flow condition is not required.

Now the 3rd aspect of the present embodiment of a method of detecting mounting failure is hereinafter described. In this embodiment, pressure of blowing air flow, rather than blowing air flow volume as in the case of previous embodiments is measured. Toward this end, among the elements forming the air sucking/blowing mechanism 10 shown in Fig. 6, reference numeral 61 is to be a pressure meter designed to measure pressure of the blowing air flow rather than air flow volume. Other structures of the air sucking/blowing mechanism 10 are the same as those of the embodiments explained so far.

As explained, when an opening of the nozzle 25 is blocked by a component 30, or when the filter 22 is clogged by dusts and/or debris, air flow volume is reduced since these obstacles may hinder air flow. When the air flow is blocked and air flow volume changes, the pressure inside air supply passage also changes simultaneously due to choking effect by these obstacles. By detecting such pressure changes, "proper mounting", "mounting failure" or "filter clogging" may be judged in a similar manner as the previous embodiments.

The nozzle 25 is in vacuum condition when sucking a component. At the time mounting a component, air pressure inside the nozzle 25 increases so as to blow air, and when mounting operation is completed and the component 30 is separated, the pressure inside the nozzle 25 gradually decreases. After the component 30 has been mounted properly, pressure inside the nozzle 25 rapidly decreases since the component 30 has been separated from the nozzle 25 by the effect of blowing air, and the nozzle opening is completely uncovered. On the contrary, in case of "mounting failure (the nozzle 25 carries back a component)", the component 30 carried by the nozzle 25 blocks the nozzle opening and blowing air flow is limited, hence pressure drop in blowing line 76 is no so rapid. In case of "nozzle clogging", the pressure would be in medial level between the above two cases. Accordingly, by comparing measured pressure data and the thresholds 1 and 2 selectively determined based on statistics data, either "proper mounting", "filter clogging", or "mounting failure" may be judged effectively in a similar manner as the previous embodiments.

As in the case of previously described other embodiments, the timing for measuring blowing air pressure of the nozzle 25 may be arranged at timing very close to mounting timing in the present embodiment too. Accordingly, a risk of making a misjudgment due to component loss during measuring timing delay may be reduced. It is also possible, as in the case of embodiment as shown in Fig. 14, measuring of air pressure may be performed at two different timings immediately after completion of component mounting, and these measured data may be used for making more accurate judgment. It is more beneficial to employ such two timing measurement method especially in the case where small nozzle 25 is used.

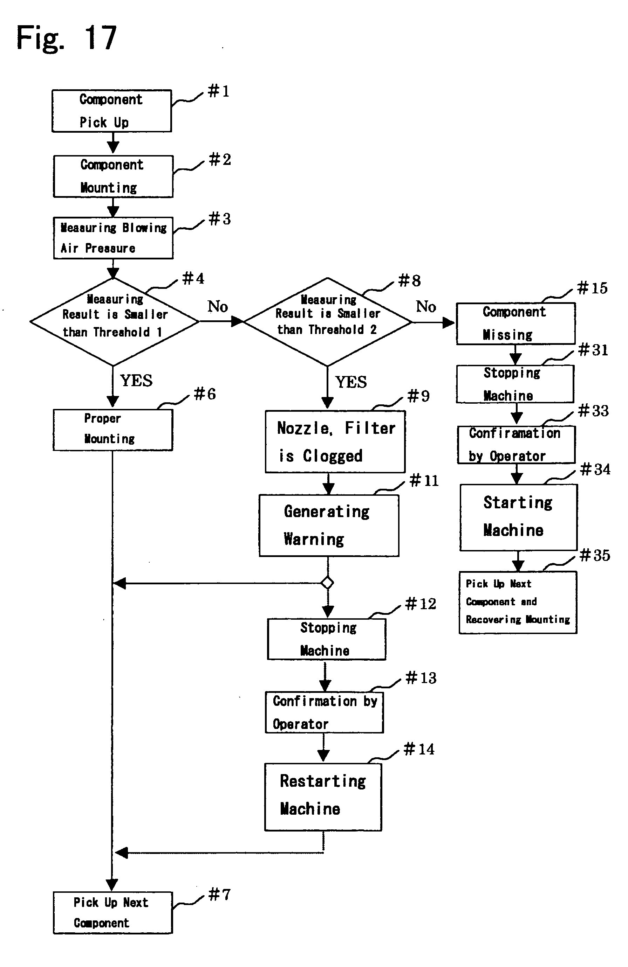

The flow chart of Fig. 17 shows procedures of detecting mounting failure of the present embodiment. The procedures shown in Fig. 17 are basically similar to those in the flowchart shown in Figs. 12 and 13, except step #3 where blowing air pressure rather than volume is measured. Other difference lies in steps #4 and #8, where measured data are compared with threshold 1 and 2, and the judgment is to be made based on whether the measurement value is smaller or not than the threshold 1 and 2, rather than bigger or not. Other procedures are the same.

In the above explanation, a pressure meter is used as an alternative or a replacement of a measuring meter used for measuring blowing air blow volume in the previous embodiments, but both air volume measuring meter and air pressure measuring meter may be used together so as to improve judgment quality and to make a comprehensive judgment by using measurement data obtained from both of the measuring devices.

Further, in the above explanation, measured result of air pressure is used for making a judgment of mounting failure etc., but it is also possible to obtain variance (differential or derivative) of air pressure change in a similar manner as the case of the second'alternative aspect shown in Fig. 15, and to make a judgment of mounting failure etc. using the result data of inclination of pressure decrease for comparing with corresponding threshold. In this case, steeper inclination is to be judged as "proper mounting", gentler inclination is to be judged as "mounting failure", and medial inclination is to be judged as "filter clogging". The measuring meter 61 in this case is designed to measure air pressure for a certain length of time, and process the measured data for obtaining pressure differential.

A method and an apparatus for mounting components having means and procedures for detecting mounting failure or component pick up failure by the nozzle has been described, but the scope of the present invention is not limited to those embodiments. For example, Fig. 1 shows a component mounting apparatus of a type having XY robot for transporting the mounting head in both X and Y directions, but the present invention may also be applied to different types of component mounting apparatus, such as the one having Y robot in which mounting head may be transported only in Y direction, or a rotary type component mounting apparatus comprising an index capable of rotating a plurality of nozzles intermittently.

While it is beneficial to employ both of the means or procedures for detecting component pick up failure by the nozzle according to the first embodiment, and means or procedures for detecting mounting failure due to component carrying back by the nozzle for avoiding occurrence of defective substrate, but it should be noted that these embodiments may be performed independently.

## Claims

1. A method of component mounting for picking up components and mounting the same onto respective predetermined mounting positions of a circuit substrate by means of a plurality of nozzles connected to a single vacuum generating source, wherein the method including procedures for preventing occurrence of defective circuit substrates due to missing component, said procedures comprising steps of:
initializing achieved vacuum pressure of a nozzle after completion of component pick up operation to zero;
detecting vacuum pressure decrease of the nozzle from the initialized zero value; and
if the detected vacuum pressure decrease exceeds predetermined first threshold, making a judgment that the nozzle has failed to pick up a component, and skipping component mounting operation by that particular nozzle.

2. The method according to claim 1, further comprising steps of:
before initializing the achieved vacuum pressure of a nozzle to zero, detecting absolute value of the vacuum pressure achieved by the nozzle after completion of component pick up operation, and
if the detected achieved vacuum pressure is lower than predetermined second threshold, shutting a vacuum air passage of that particular nozzle.

3. The method according to claim 2, further comprising steps of:
imaging each of the nozzles with a recognition camera; and
identifying which nozzle has failed to pick up a component based on the obtained images.

4. The method according to claim 3, further comprising steps of:
after identifying the nozzle that has failed to pick up a component based on the obtained images, shutting a vacuum air passage of that identified nozzle;
imaging the identified nozzle one more time, and detecting whether or not a component is still carried by the nozzle.

5. The method according to claim 2, wherein the nozzles perform component mounting operations, excluding the nozzle that is judged to have failed to pick up a component and the nozzle whose vacuum air passage is shut.

6. Component mounting apparatus comprising:
a vacuum generating source;
a plurality of nozzles connected to said vacuum generating source, each of which nozzles has a control valve capable of shutting a vacuum air passage;
a mounting head being supported in a movable manner and holding said plurality of nozzles;
a component recognition device positioned to face with the mounting head for recognizing components held by the nozzles; and
a controller for controlling operations of the component mounting apparatus in accordance with a method according to any one of the preceding claims.

7. A method of component mounting for picking up a component by means of vacuum sucking effect of a nozzle, and separating the component from the nozzle and mounting the same onto a predetermined mounting position of a circuit substrate by means of air blowing effect of the nozzle, wherein the method including procedures for preventing occurrence of defective substrates, which procedures comprising steps of;
measuring air flow volume blown from the nozzle at an air flow passage at a timing immediately after completion of component mounting operation, which air flow passage is provided for supplying pressurized air to the nozzle; and
making a judgment that the component has not been mounted onto the circuit substrate, if the measurement value is smaller than a predetermined threshold.

8. The method according to claim 7, wherein the threshold comprising two thresholds, and said procedures comprising steps of:
making a judgment that the component has not been mounted onto the circuit substrate, if the measurement value is smaller than both of the thresholds; and
making a judgment that the component has been mounted onto the circuit substrate, but that a filter disposed at the air flow passage is clogged, if the measurement value is in between the two thresholds.

9. The method according to claim 8, wherein said procedures comprising steps of:
measuring blowing air flow volume at two different timings immediately after completion of component mounting operation;
making a judgment whether or not the component has been properly mounted onto the circuit substrate based on the first measurement value; and
making a judgment either the component has been mounted onto the circuit substrate but the filter is clogged, or the component has not been mounted onto the circuit substrate based on the second measurement value.

10. A method of component mounting for picking up a component by means of vacuum sucking effect of a nozzle, and separating the component from the nozzle and mounting the same onto a predetermined mounting position of a circuit substrate by means of air blowing effect of the nozzle, wherein the method including procedures for preventing occurrence of defective substrates, which procedures comprising steps of;
measuring differential of air flow volume blown from the nozzle at an air flow passage at a timing immediately after completion of component mounting operation, which air flow passage is provided for supplying pressurized air to the nozzle; and
making a judgment that the component has not been mounted onto the circuit substrate, if the differential of air flow volume decrease obtained by the measurement is bigger than a predetermined threshold.

11. The method according to claim 10, wherein the threshold comprising two thresholds, and said procedures comprising steps of:
making a judgment that the component has not been mounted onto the circuit substrate, if the differential of air flow volume decrease obtained by the measurement is bigger than both of the thresholds; and
making a judgment that the component has been mounted onto the circuit substrate, but that a filter disposed at the air flow passage is clogged, if the differential of air flow volume decrease obtained by the measurement is bigger than one of the thresholds but smaller than the other.

12. The method according to claim 11, wherein said procedures comprising steps of:
measuring differential of air flow volume at two different timings immediately after completion of component mounting operation;
making a judgment whether or not the component has been properly mounted onto the circuit substrate based on the first measurement result; and
making a judgment either the component has been mounted onto the circuit but the filter is clogged, or the component has not been mounted onto the circuit substrate based on the second measurement result.

13. A method of component mounting for picking up a component by means of vacuum sucking effect of a nozzle, and separating the component from the nozzle and mounting the same onto a predetermined mounting position of a circuit substrate by means of air blowing effect of the nozzle, wherein the method including procedures for preventing occurrence of defective substrates, which procedures comprising steps of;
measuring blowing air pressure blown from the nozzle at an air flow passage at a timing immediately after completion of component mounting operation, which air flow passage is provided for supplying pressurized air to the nozzle; and
making a judgment that the component has not been mounted onto the circuit substrate, if the measurement value is bigger than a predetermined threshold.

14. The method according to claim 13, wherein the threshold comprising two thresholds, and said procedures comprising steps of:
making a judgment that the component has not been properly mounted onto the circuit substrate, if the measurement value is bigger than both of the thresholds; and
making a judgment that the component has been mounted onto the circuit substrate, but that a filter disposed at the air flow passage is clogged, if the measurement value is in between the two thresholds.

15. The method according to claim 14, wherein said procedures comprising steps of:
measuring blowing air pressure at two different timings immediately after completion of component mounting operation;
making a judgment whether or not the component has been properly mounted onto the circuit substrate based on the first measurement value; and
making a judgment either the component has been mounted onto the circuit substrate but the filter is clogged, or the component has not been mounted onto the circuit substrate based on the second measurement value.

16. A method of component mounting for picking up a component by means of vacuum sucking effect of a nozzle, and separating the component from the nozzle and mounting the same onto a predetermined mounting position of a circuit substrate by means of air blowing effect of the nozzle, wherein the method including procedures for preventing occurrence of defective substrates, which procedures comprising steps of;
measuring differential of blowing air pressure blown from the nozzle at an air flow passage at a timing immediately after completion of component mounting operation, which air flow passage is provided for supplying pressurized air to the nozzle; and
making a judgment that the component has not been mounted onto the circuit substrate, if the differential of blowing air pressure decrease obtained by the measurement is smaller than a predetermined threshold.

17. The method according to claim 16, wherein the threshold comprising two thresholds, and said procedures comprising steps of:
making a judgment that the component has not been mounted onto the circuit substrate, if the differential of blowing air pressure decrease obtained by the measurement is smaller than both of the thresholds; and
making a judgment that the component has been mounted onto the circuit substrate, but that a filter disposed at the air flow passage is clogged, if the differential of blowing air pressure decrease obtained by the measurement is smaller than one of the thresholds but bigger than the other.

18. The method according to claim 17, wherein said procedures comprising steps of:
measuring differential of air flow volume at two different timings immediately after completion of component mounting operation;
making a judgment whether or not the component has been properly mounted onto the circuit substrate based on the first measurement result; and
making a judgment either the component has been mounted onto the circuit but the filter is clogged, or the component has not been mounted onto the circuit substrate based on the second measurement result.

19. A method of component mounting for picking up a component by means of vacuum sucking effect of a nozzle, and separating the component from the nozzle and mounting the same onto a predetermined mounting position of a circuit substrate by means of air blowing effect of the nozzle, wherein the method including procedures for preventing occurrence of defective substrates, which procedures comprising steps of;
measuring either one of blowing air flow volume, differential of blowing air flow volume decrease, blowing air pressure, or differential of blowing air pressure decrease of the air blown from the nozzle at an air flow passage at a timing immediately after completion of component mounting operation, which air flow passage is provided for supplying pressurized air to the nozzle;
comparing the result of the measurement with a predetermined corresponding threshold;
making a judgment that the component has been separated from the nozzle and mounted onto the circuit substrate properly, if the blowing air flow volume or the differential of blowing air pressure decrease is bigger than the corresponding predetermined threshold, or the differential of blowing air volume decrease or blowing air pressure is smaller than the corresponding predetermined threshold, and then performing next round component pick up operation;
making a judgment that the component has not been separated from the nozzle and that the circuit substrate is missing the component, if the blowing air flow volume or the differential of blowing air pressure decrease is smaller than the corresponding predetermined threshold, or the differential of blowing air volume decrease or blowing air pressure is bigger than the corresponding predetermined threshold;
stopping the component mounting apparatus;
checking the nozzle, removing the component carried by the nozzle, and confirming that the nozzle is in a proper condition; and
restarting the component mounting apparatus for next round component pick up operation.

20. A method of component mounting for picking up a component by means of vacuum sucking effect of a nozzle, and separating the component from the nozzle and mounting the same onto a predetermined mounting position of a circuit substrate by means of air blowing effect of the nozzle, wherein the method including procedures for preventing occurrence of defective substrates, which procedures comprising steps of;
measuring either one of blowing air flow volume, differential of blowing air flow volume decrease, blowing air pressure, or differential of blowing air pressure decrease of the air blown from the nozzle at an air flow passage at a timing immediately after completion of component mounting operation, which air flow passage is provided for supplying pressurized air to the nozzle;
comparing the result of the measurement with a first predetermined corresponding threshold;
making a judgment that the component has been separated from the nozzle and mounted onto the circuit substrate properly, if the blowing air flow volume or the differential of blowing air pressure decrease is bigger than the corresponding predetermined first thresholds, or the differential of blowing air flow volume decrease or blowing air pressure is smaller than the corresponding predetermined first threshold, and then performing next round component pick up operation;
comparing the result of the measurement with a second corresponding predetermined threshold, if the blowing air flow volume or the differential of blowing air pressure decrease is smaller than the corresponding predetermined first threshold, or the differential of blowing air flow volume decrease or the blowing air pressure is bigger than the corresponding predetermined first threshold;
making a judgment that the component has been mounted onto the circuit substrate but that a filter disposed at an air flow passage is clogged, and generating an alarm, if the blowing air flow volume or the differential of blowing air pressure decrease is bigger than the corresponding predetermined second thresholds, or the differential of blowing air flow volume decrease or blowing air pressure is smaller than the corresponding predetermined second threshold;
making a judgment that the component has not been separated from the nozzle and that the circuit substrate is missing the component, if the blowing air flow volume or the differential of blowing air pressure decrease is smaller than the corresponding predetermined second threshold, or the differential of blowing air volume decrease or the blowing air pressure is bigger than the corresponding predetermined second threshold;
stopping the component mounting apparatus;
checking the nozzle, removing the component carried by the nozzle, and confirming that the nozzle is in a proper condition; and
restarting the component mounting apparatus for next round component pick up operation.

21. The method according to claim 20, wherein, after the step of generating an alarm, said procedures further comprising steps of:
stopping the component mounting apparatus;
checking the nozzle, removing the component carried by the nozzle, and confirming that the nozzle is in a proper condition; and
restarting the component mounting apparatus for next round component pick up operation.

22. The method according to claim 20, wherein the procedures comprising step of:
measuring either one of blowing air flow volume, differential of blowing air flow volume decrease, blowing air pressure, or differential of blowing air pressure decrease of the air blown from the nozzle at an air flow passage at two different timings immediately after completion of component mounting operation, which air flow passage is provided for supplying pressurized air to the nozzle;
comparing the result of the first measurement with the first threshold; and
comparing the result of the second measurement with the second threshold.

23. The method according to claim 19, wherein, between the step of making a judgment that the circuit substrate is missing a component and the step of stopping the component mounting apparatus, said procedures further comprising steps of:
discarding the component carried by the nozzle;
skipping the component pick up and component mounting operations at next round component mounting cycle;
measuring either one of blowing air flow volume, differential of blowing air flow volume decrease, blowing air pressure, or differential of blowing air pressure decrease of the air blown from that particular nozzle at a timing immediately after air blowing operation;
comparing the result of the measurement with the corresponding predetermined threshold or the first threshold;
making a judgment that the component has been discarded properly and performing next round component pick up operation without stopping the component mounting apparatus, if the blowing air flow volume or the differential of blowing air pressure decrease is bigger than the corresponding predetermined threshold or the first threshold, or the differential of blowing air flow volume decrease or blowing air pressure is smaller than the corresponding predetermined threshold or the first threshold, and then performing next round component pick up, operation;
making a judgment that the component has not been discarded properly, if the blowing air flow volume or the differential of blowing air pressure decrease is smaller than the corresponding predetermined threshold or the first threshold, or the differential of blowing air flow volume decrease or blowing air pressure is bigger than the corresponding predetermined threshold or the first threshold.

24. The method according to claim 19, wherein after the step of making a judgment that the circuit substrate is missing a component, said procedures further comprising a step of confirming whether or not the component to be mounted on the circuit substrate is actually missing from the circuit substrate by checking that particular circuit substrate.

25. The method according to claim 19, wherein when it is judged that the circuit substrate is missing a component, the procedures further includes steps of:
picking up the missing component; and
mounting the component onto that particular circuit substrate for recovering the missing component.

26. A component mounting apparatus comprising:
component supply for supplying component continuously;
a mounting head having nozzles for picking up components from the component supply by means of air sucking effect, and separating and mounting the components onto predetermine respective mounting positions of a circuit substrate by means of air blowing effect;
a substrate holder for transporting and positioning the circuit substrate;
an air sucking/blowing mechanism connected to the nozzles for providing air sucking effect and air blowing effect to the nozzle; and
a controller for controlling overall operations of the component mounting apparatus, wherein the air sucking/blowing mechanism further comprising:
either one of a measuring meter capable of measuring blowing air flow volume or differential of the blowing air flow volume, or a pressure meter capable of measuring blowing air pressure or differential of the blowing air pressure, either one of which is disposed at an air flow passage for supplying pressurized air to the nozzle, and for measuring either blowing air volume or pressure at a timing immediately after completion of blowing air; and
a controller for comparing the measuring result obtained by either one of the meters with a corresponding preliminary inputted threshold, and for making a judgment whether or not the component has been mounted properly.

27. The component mounting apparatus according to claim 26, wherein the preliminary inputted threshold comprising two thresholds, and the controller being designed to make a judgment whether or not the component has been mounted properly or not based on comparison between the measurement result and the first threshold, and/or making judgment either the component has been mounted onto the circuit substrate but the filter is clogged, or the component has not been mounted onto the circuit substrate based on comparison between the measurement result and the second threshold.

28. The component mounting apparatus according to claim 27, wherein the measuring meter or the pressure meter measuring either one of blowing air flow volume, differential of blowing air flow volume decrease, blowing air pressure or differential of blowing air pressure decrease at two different timings immediately after air blowing operation; and
the controller making a judgment whether or not the component has been properly mounted onto the circuit substrate based on comparison between the first measurement result and the corresponding first threshold, and making a judgment either the a filter disposed at air flow passage is clogged, or the component has not been mounted based on comparison between the second measurement value and the corresponding second threshold.

29. The component mounting apparatus according to claim 26, wherein the nozzle is structured to suck a component having a span length of equal to or less than 1.0mm.
